(19) Europäisches Patentamt
European Patent Office
Office européen des brevets

(11) EP 3 640 972 A1

(12) EUROPEAN PATENT APPLICATION

(43) Date of publication:
22.04.2020 Bulletin 2020/17

(51) Int Cl.:
H01L 21/306 (2006.01)     H01L 21/321 (2006.01)
B24B 37/00 (2012.01)     B24B 49/00 (2012.01)
B24B 49/04 (2006.01)     B24B 49/12 (2006.01)
B24B 49/16 (2006.01)     H01L 21/66 (2006.01)

(21) Application number: 18201087.6

(22) Date of filing: 18.10.2018

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: ASML Netherlands B.V.
5500 AH Veldhoven (NL)

(72) Inventors:
• ZHANG, Huaichen
  5500 AH Veldhoven (NL)
• VAN LARE, Marie-Claire
  5500 AH Veldhoven (NL)

(74) Representative: Peters, John Antoine
ASML Netherlands BV
Corporate Intellectual Property
De Run 6501
P.O. Box 324
5500 AH Veldhoven (NL)

(54) **SYSTEM AND METHOD FOR FACILITATING CHEMICAL MECHANICAL POLISHING**

(57)     Described herein is a method for facilitating chemical mechanical polishing. The method comprises determining contact mechanics information indicative of contact pressures and friction forces between a wafer and a pad during the chemical mechanical polishing at a plurality of locations across the wafer. The contact pressures and friction forces are asymmetrically distributed across the wafer. The method also includes determining a post chemical mechanical polishing surface topography of the wafer based at least on the contact mechanics information.

FIG. 10

**Description**

TECHNICAL FIELD

The description herein relates generally to a patterning process and a metrology apparatus. More particularly, the description relates to an apparatus or a method for facilitating chemical mechanical polishing (CMP).

BACKGROUND

A lithography apparatus is a machine that applies a desired pattern onto a target portion of a substrate. Lithography apparatus can be used, for example, in the manufacture of integrated circuits (ICs). In that circumstance, a patterning device, which is alternatively referred to as a mask or a reticle, may be used to generate a circuit pattern corresponding to an individual layer of the IC, and this pattern can be imaged onto a target portion (e.g. comprising part of, one, or several dies) on a substrate (e.g., a silicon wafer) that has a layer of radiation-sensitive material (resist). In general, a single substrate will include a network of adjacent target portions that are successively exposed. Known lithography apparatus include steppers, in which target portions are irradiated by exposing a pattern onto the target portion, and scanners, in which target portions are irradiated by scanning the pattern through the beam in a given direction (the "scanning"-direction) while synchronously scanning the substrate parallel or anti parallel to this direction.

Prior to transferring the circuit pattern from the patterning device to the substrate, the substrate may undergo various procedures, such as priming, resist coating and a soft bake. After exposure, the substrate may be subjected to other procedures, such as a post-exposure bake (PEB), development, a hard bake and measurement/inspection of the transferred circuit pattern. This array of procedures is used as a basis to make an individual layer of a device, e.g., an IC. The substrate may then undergo various processes such as etching, ion-implantation (doping), metallization, oxidation, chemical mechanical polishing, etc., all intended to finish the individual layer of the device. If several layers are required in the device, then the whole procedure, or a variant thereof, is repeated for each layer. Eventually, a device will be present in each target portion on the substrate. These devices are then separated from one another by a technique such as dicing or sawing, where the individual devices can be mounted on a carrier, connected to pins, etc.

Manufacturing devices, such as semiconductor devices, typically involves processing a substrate (e.g., a semiconductor wafer) using a number of fabrication processes to form various features and multiple layers of the devices. Such layers and features are typically manufactured and processed using, e.g., deposition, lithography, etch, chemical mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern on the patterning device to a substrate and typically, but optionally, involves one or more related pattern processing steps, such as resist development by a development apparatus, baking of the substrate using a bake tool, etching the pattern using an etch apparatus, etc.

SUMMARY

According to an embodiment, there is provided a method for facilitating chemical mechanical polishing. The method comprises determining contact mechanics information indicative of contact pressures and friction forces between a wafer and a pad during the chemical mechanical polishing at a plurality of locations across the wafer. The contact pressures and friction forces are asymmetrically distributed across the wafer. The method comprises determining a post chemical mechanical polishing surface topography of the wafer based at least on the contact mechanics information.

In an embodiment, the method further comprises determining load distribution information indicative of forces between the wafer and the pad during the chemical mechanical polishing. The load distribution information is determined based on asperities of the wafer and the pad. In this embodiment, the method further comprises determining kinematic information comprising one or more parameters related to motion of the wafer and the pad during the chemical mechanical polishing. The contact mechanics information is determined based on the load distribution information and the kinematic information. Determining the post chemical mechanical polishing surface topography of the wafer is further based on the load distribution information and the kinematic information.

In an embodiment, determining the contact mechanics information comprises generating an influential coefficient matrix comprising kernel functions that relate surface deformation of the wafer and the contact pressures.

In an embodiment, the method further comprises obtaining geometric parameters associated with the wafer, and determining the post chemical mechanical polishing surface topography of the wafer based on the load distribution information, the kinematic information, the contact mechanics information, and the geometric parameters associated with the wafer.

In an embodiment, the geometric parameters associated with the wafer include one or more of a pre-chemical mechanical polishing surface topography, parameters related to materials in a wafer stack of the wafer, a wafer stack height map, or coordinates of one or more locations on the wafer.

In an embodiment, the method further comprises obtaining physical parameters associated with the wafer, the pad, and/or a simulated chemical mechanical polishing process; and determining the load distribution information, the kinematic information, and/or the contact mechanics information based on the physical parameters.

In an embodiment, the physical parameters comprise one or more of an elastic modulus of the pad, a Poisson ratio for the pad, a pad asperity model, a pad asperity characteristic length, a pad asperity tip average radius, a pad asperity density, an elastic modulus of the wafer, a Poisson ratio for the wafer, a polishing speed constant, a friction coefficient, a pad rotation speed, a wafer rotation speed, a distance between the wafer and the pad, or parameters related to a simulated polishing slurry.

In an embodiment, the method further comprises simulating removing material from the wafer based on the load distribution information, the kinematic information, and the contact mechanics information, and determining the post chemical mechanical polishing surface topography of the wafer based on the load distribution information, the kinematic information, the contact mechanics information, and the removed material.

In an embodiment, the load distribution information comprises a number of points on the wafer where asperity loads are discretized. In an embodiment, the number of points is adjustable.

In an embodiment, one of the one or more parameters related to the motion of the wafer and the pad is a number of polishing directions. In an embodiment, the number of polishing directions is adjustable.

In an embodiment, at least a portion of the contact mechanics information is determined by a matrix inversion solver or a linear complimentary problem solver.

In an embodiment, the contact mechanics information comprises an asymmetric pressure profile.

In an embodiment, the post chemical mechanical polishing surface topography of the wafer is determined based on the load distribution information, the kinematic information, and the contact mechanics information for one or more of process modelling, metrology correction, feedforward control, or process integration for chemical mechanical polishing in a semiconductor manufacturing process.

In an embodiment, the post chemical mechanical polishing surface topography of the wafer is used to determine grating asymmetry in optical alignment marks used in a semiconductor manufacturing process.

In an embodiment, determining the post chemical mechanical polishing surface topography of the wafer based on the load distribution information, the kinematic information, and the contact mechanics information comprises generating an output wafer stack height map.

In an embodiment, the post chemical mechanical polishing surface topography of the wafer is further determined based on Preston's Equation.

In an embodiment, the asperities of the wafer and the pad are determined based on a pad asperity model and a stack height map of the wafer.

In an embodiment, the method further comprises causing, based on the determined post chemical mechanical polishing surface topography, performance of the chemical mechanical polishing.

According to another embodiment, there is provided a method for facilitating chemical mechanical polishing. The method comprises determining contact mechanics information indicative of contact pressures and friction forces between a wafer and a pad during the chemical mechanical polishing at a plurality of locations across the wafer. The contact pressures and friction forces are asymmetrically distributed across the wafer. The method comprises determining a post chemical mechanical polishing surface topography of the wafer based at least on the contact mechanics information. The post chemical mechanical polishing surface topography of the wafer is determined for one or more of process modelling, metrology correction, feedforward control, or process integration for chemical mechanical polishing in a semiconductor manufacturing process.

In an embodiment, the method further comprises determining load distribution information indicative of forces between the wafer and the pad during the chemical mechanical polishing. The load distribution information is determined based on asperities of the wafer and the pad. The method further comprises determining kinematic information comprising one or more parameters related to motion of the wafer and the pad during the chemical mechanical polishing. The contact mechanics information is determined based on the load distribution information and the kinematic information. Determining the post chemical mechanical polishing surface topography of the wafer is further based on the load distribution information and the kinematic information.

In an embodiment, determining the contact mechanics information comprises generating an influential coefficient matrix comprising kernel functions that relate surface deformation of the wafer and the contact pressures. In an embodiment, the influential coefficient matrix is asymmetric.

In an embodiment, method further comprises obtaining geometric parameters associated with the wafer, and determining the post chemical mechanical polishing surface topography of the wafer based on the load distribution information, the kinematic information, the contact mechanics information, and the geometric parameters associated with the wafer.

According to another embodiment, there is provided a method for facilitating chemical mechanical polishing. The method comprises determining contact mechanics information indicative of contact pressures and friction forces between a wafer and a pad during the chemical mechanical polishing at a plurality of locations across the wafer. The contact pressures and friction forces are asymmetrically distributed across the wafer. The method comprises determining a post chemical mechanical polishing surface topography of the wafer based at least on the contact mechanics information. The method comprises causing, based on the determined post chemical mechanical polishing surface topography, performance of the chemical mechanical polishing.

According to another embodiment, there is provided a computer program product comprising a non-transitory computer readable medium having instructions recorded thereon, the instructions when executed by a computer implementing the methods discussed above.

BRIEF DESCRIPTION OF THE DRAWINGS

Figure 1 schematically depicts a lithography apparatus according to an embodiment.

Figure 2 schematically depicts an embodiment of a lithographic cell or cluster according to an embodiment.

Figure 3 schematically depicts an example inspection apparatus and metrology technique according to an embodiment.

Figure 4 schematically depicts an example inspection apparatus according to an embodiment.

Figure 5 illustrates the relationship between an illumination spot of an inspection apparatus and a metrology target according to an embodiment.

Figure 6 schematically depicts a process of deriving a plurality of variables of interest based on measurement data according to an embodiment.

Figure 7A is a flow chart showing various stages of a 'design for control' process flow, according to an embodiment.

Figure 7B is a block diagram showing various stages for visualization, according to an embodiment.

Figure 7C is a flow chart showing how the 'design for control' process determines metrology target designs robust against process perturbations, according to an embodiment.

Figure 8 illustrates a typical chemical mechanical polishing apparatus, according to an embodiment.

Figure 9 is a cross-sectional illustration of chemical mechanical polishing performed on a wafer as part of a semiconductor manufacturing process.

Figure 10 illustrates various operations that are performed by the present system(s) and/or are part of the present method(s), according to an embodiment.

Figure 11 illustrates several combinations of input parameters used to determine load distribution information, kinematics information, an influential coefficient matrix, material removal information, and/or other information according to an embodiment.

Figure 12 illustrates a hypothetical far field pad bulk, pad asperities, and a wafer surface, according to an embodiment.

Figure 13 illustrates a wafer and a pad rotating relative to each other, according to an embodiment.

Figure 14 illustrates cross-sectional views of output geometry, according to an embodiment.

Figure 15 schematically depicts an embodiment of a scanning electron microscope (SEM), according to an embodiment.

Figure 16 schematically depicts an embodiment of an electron beam inspection apparatus, according to an embodiment.

Figure 17 is a block diagram of an example computer system according to an embodiment.

Figure 18 is a schematic diagram of another lithographic projection apparatus according to an embodiment.

Figure 19 is a more detailed view of the apparatus in Figure 18 according to an embodiment.

Figure 20 is a more detailed view of the source collector module of the apparatus of Figure 18 and Figure 19 according to an embodiment.

Embodiments will now be described in detail with reference to the drawings, which are provided as illustrative examples to enable those skilled in the art to practice the embodiments. Notably, the figures and examples below are not meant to limit the scope to a single embodiment, but other embodiments are possible by way of interchange of some or all of the described or illustrated elements. Wherever convenient, the same reference numbers will be used throughout the drawings to refer to same or like parts. Where certain elements of these embodiments can be partially or fully implemented using known components, only those portions of such known components that are necessary for an understanding of the embodiments will be described, and detailed descriptions of other portions of such known components will be omitted so as not to obscure the description of the embodiments. In the present specification, an embodiment showing a singular component should not be considered limiting; rather, the scope is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the scope encompasses present and future known equivalents to the components referred to herein by way of illustration.

DETAILED DESCRIPTION

The description set forth below in connection with the appended drawings is intended as a description of various embodiments of the disclosed subject matter and is not necessarily intended to represent the only embodiment(s). In certain instances, the description includes specific details for the purpose of providing an understanding of the disclosed embodiment(s). However, it will be apparent to those skilled in the art that the disclosed embodiment(s) may be practiced without those specific details. In some instances, well-known structures and components may be shown in block diagram form in order to avoid obscuring the concepts of the disclosed subject matter.

Before describing embodiments in detail, it is instructive to present an example environment in which embodiments may be implemented.

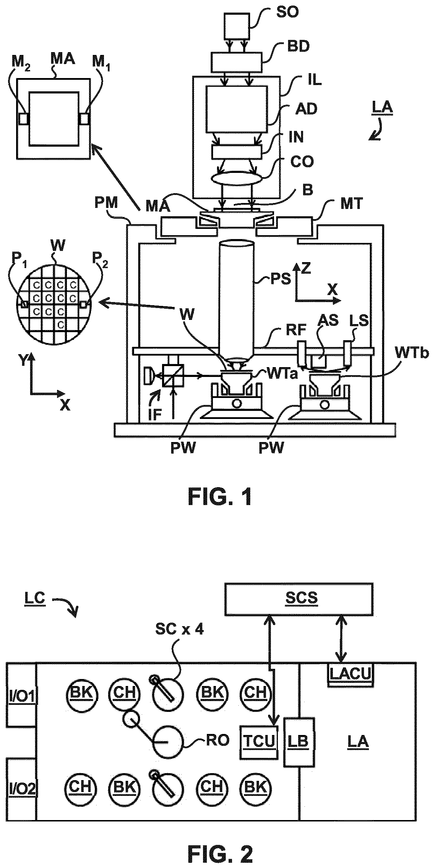

Figure 1 schematically depicts an embodiment of a lithographic apparatus LA. The apparatus comprises:

- an illumination system (illuminator) IL configured to condition a radiation beam B (e.g. UV radiation or DUV radiation);
- a support structure (e.g. a mask table) MT constructed to support a patterning device (e.g. a mask) MA and connected to a first positioner PM configured to accurately position the patterning device in accordance with certain parameters;
- a substrate table (e.g. a wafer table) WT (e.g., WTa, WTb or both) constructed to hold a substrate (e.g. a resist-coated wafer) W and connected to a second positioner PW configured to accurately position the substrate in accordance with certain parameters; and
- a projection system (e.g. a refractive projection lens system) PS configured to project a pattern imparted to the radiation beam B by patterning device MA onto a target portion C (e.g. comprising one or more dies and often referred to as fields) of the substrate W, the projection system supported on a reference frame (RF).

As depicted in Figure 1, the apparatus is of a transmissive type (e.g. employing a transmissive mask). Alternatively, the apparatus may be of a reflective type (e.g. employing a programmable mirror array of a type as referred to above, or employing a reflective mask).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be an integral part of the apparatus, for example when the source is a mercury lamp. The source SO and the illuminator IL, together with the beam delivery system BD if required, may be referred to as a radiation system.

The illuminator IL may alter the intensity distribution of the beam. The illuminator may be arranged to limit the radial extent of the radiation beam such that the intensity distribution is non-zero within an annular region in a pupil plane of the illuminator IL. Additionally or alternatively, the illuminator IL may be operable to limit the distribution of the beam in the pupil plane such that the intensity distribution is non-zero in a plurality of equally spaced sectors in the pupil plane. The intensity distribution of the radiation beam in a pupil plane of the illuminator IL may be referred to as an illumination mode.

The illuminator IL may comprise adjuster AM configured to adjust the (angular / spatial) intensity distribution of the beam. Generally, at least the outer and/or inner radial extent (commonly referred to as $\sigma$-outer and $\sigma$-inner, respectively) of the intensity distribution in a pupil plane of the illuminator can be adjusted. The illuminator IL may be operable to vary the angular distribution of the beam. For example, the illuminator may be operable to alter the number, and angular extent, of sectors in the pupil plane wherein the intensity distribution is non-zero. By adjusting the intensity distribution of the beam in the pupil plane of the illuminator, different illumination modes may be achieved. For example, by limiting the radial and angular extent of the intensity distribution in the pupil plane of the illuminator IL, the intensity distribution may have a multi-pole distribution such as, for example, a dipole, quadrupole or hexapole distribution. A desired illumination mode may be obtained, e.g., by inserting an optic which provides that illumination mode into the illuminator IL or using a spatial light modulator.

The illuminator IL may be operable to alter the polarization of the beam and may be operable to adjust the polarization using adjuster AM. The polarization state of the radiation beam across a pupil plane of the illuminator IL may be referred to as a polarization mode. The use of different polarization modes may allow greater contrast to be achieved in the image formed on the substrate W. The radiation beam may be unpolarized. Alternatively, the illuminator may be arranged to linearly polarize the radiation beam. The polarization direction of the radiation beam may vary across a pupil plane of the illuminator IL. The polarization direction of radiation may be different in different regions in the pupil plane of the illuminator IL. The polarization state of the radiation may be chosen depending on the illumination mode. For multi-pole illumination modes, the polarization of each pole of the radiation beam may be generally perpendicular to the position vector of that pole in the pupil plane of the illuminator IL. For example, for a dipole illumination mode, the radiation may be linearly polarized in a direction that is substantially perpendicular to a line that bisects the two opposing sectors of the dipole. The radiation beam may be polarized in one of two different orthogonal directions, which may be referred to as X-polarized and Y-polarized states. For a quadrupole illumination mode the radiation in the sector of each pole may be linearly polarized in a direction that is substantially perpendicular to a line that bisects that sector. This polarization mode may be referred to as XY polarization. Similarly, for a hexapole illumination mode the radiation in the sector of each pole may be linearly polarized in a direction that is substantially perpendicular to a line that bisects that sector. This polarization mode may be referred to as TE polarization.

In addition, the illuminator IL generally comprises various other components, such as an integrator IN and a condenser CO. The illumination system may include various types of optical components, such as refractive, reflective, magnetic, electromagnetic, electrostatic or other types of optical components, or any combination thereof, for directing, shaping, or controlling radiation.

Thus, the illuminator provides a conditioned beam of radiation B, having a desired uniformity and intensity distribution in its cross section.

The support structure MT supports the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a pattern in a target portion of the substrate. In an embodiment, a patterning device is any device that can be used to impart a radiation beam with a pattern in its cross-section to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

A patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted to reflect an incoming radiation beam in different directions. The tilted mirrors impart a pattern in a radiation beam, which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The projection system PS has an optical transfer function that may be non-uniform, which can affect the pattern imaged on the substrate W. For unpolarized radiation such effects can be fairly well described by two scalar maps, which describe the transmission (apodization) and relative phase (aberration) of radiation exiting the projection system PS as a function of position in a pupil plane thereof. These scalar maps, which may be referred to as the transmission map and the relative phase map, may be expressed as a linear combination of a complete set of basis functions. A particularly convenient set is the Zernike polynomials, which form a set of orthogonal polynomials defined on a unit circle. A determination of each scalar map may involve determining the coefficients in such an expansion. Since the Zernike polynomials are orthogonal on the unit circle, the Zernike coefficients may be determined by calculating the inner product of a measured scalar map with each Zernike polynomial in turn and dividing this by the square of the norm of that Zernike polynomial.

The transmission map and the relative phase map are field and system dependent. That is, in general, each projection system PS will have a different Zernike expansion for each field point (i.e. for each spatial location in its image plane). The relative phase of the projection system PS in its pupil plane may be determined by projecting radiation, for example from a point-like source in an object plane of the projection system PS (i.e. the plane of the patterning device MA), through the projection system PS and using a shearing interferometer to measure a wavefront (i.e. a locus of points with the same phase). A shearing interferometer is a common path interferometer and therefore, advantageously, no secondary reference beam is required to measure the wavefront. The shearing interferometer may comprise a diffraction grating, for example a two dimensional grid, in an image plane of the projection system (i.e. the substrate table WT) and a detector arranged to detect an interference pattern in a plane that is conjugate to a pupil plane of the projection system PS. The interference pattern is related to the derivative of the phase of the radiation with respect to a coordinate in the pupil plane in the shearing direction. The detector may comprise an array of sensing elements such as, for example, charge coupled devices (CCDs).

The projection system PS of a lithography apparatus may not produce visible fringes and therefore the accuracy of the determination of the wavefront can be enhanced using phase stepping techniques such as, for example, moving the diffraction grating. Stepping may be performed in the plane of the diffraction grating and in a direction perpendicular to the scanning direction of the measurement. The stepping range may be one grating period, and at least three (uniformly distributed) phase steps may be used. Thus, for example, three scanning measurements may be performed in the y-direction, each scanning measurement being performed for a different position in the x-direction. This stepping of the diffraction grating effectively transforms phase variations into intensity variations, allowing phase information to be determined. The grating may be stepped in a direction perpendicular to the diffraction grating (z direction) to calibrate the detector.

The diffraction grating may be sequentially scanned in two perpendicular directions, which may coincide with axes of a co-ordinate system of the projection system PS (x and y) or may be at an angle such as 45 degrees to these axes. Scanning may be performed over an integer number of grating periods, for example one grating period. The scanning averages out phase variation in one direction, allowing phase variation in the other direction to be reconstructed. This allows the wavefront to be determined as a function of both directions.

The transmission (apodization) of the projection system PS in its pupil plane may be determined by projecting radiation, for example from a point-like source in an object plane of the projection system PS (i.e. the plane of the patterning device MA), through the projection system PS and measuring the intensity of radiation in a plane that is conjugate to a pupil plane of the projection system PS, using a detector. The same detector as used to measure the wavefront to determine aberrations may be used.

The projection system PS may comprise a plurality of optical (e.g., lens) elements and may further comprise an adjustment mechanism AM configured to adjust one or more of the optical elements to correct for aberrations (phase variations across the pupil plane throughout the field). To achieve this, the adjustment mechanism may be operable to manipulate one or more optical (e.g., lens) elements within the projection system PS in one or more different ways. The projection system may have a co-ordinate system wherein its optical axis extends in the z direction. The adjustment mechanism may be operable to do any combination of the following: displace one or more optical elements; tilt one or more optical elements; and/or deform one or more optical elements. Displacement of an optical element may be in any direction (x, y, z or a combination thereof). Tilting of an optical element is typically out of a plane perpendicular to the optical axis, by rotating about an axis in the x and/or y directions although a rotation about the z-axis may be used for a non-rotationally symmetric aspherical optical element. Deformation of an optical element may include a low frequency shape (e.g. astigmatic) and/or a high frequency shape (e.g. free form aspheres). Deformation of an optical element may be performed for example by using one or more actuators to exert force on one or more sides of the optical element and/or by using one or more heating elements to heat one or more selected regions of the optical element. In general, it may not be possible to adjust the projection system PS to correct for apodization (transmission variation across the pupil plane). The transmission map of a projection system PS may be used when designing a patterning device (e.g., mask) MA for the lithography apparatus LA. Using a computational lithography technique, the patterning device MA may be designed to at least partially correct for apodization.

The lithographic apparatus may be of a type having two (dual stage) or more tables (e.g., two or more substrate tables WTa, WTb, two or more patterning device tables, a substrate table WTa and a table WTb below the projection system without a substrate that is dedicated to, for example, facilitating measurement, and/or cleaning, etc.). In such "multiple stage" machines, the additional tables may be used in parallel, or preparatory steps may be carried out on one or more tables while one or more other tables are being used for exposure. For example, alignment measurements using an alignment sensor AS and/or level (height, tilt, etc.) measurements using a level sensor LS may be made.

The lithographic apparatus may also be of a type wherein at least a portion of the substrate may be covered by a liquid having a relatively high refractive index, e.g. water, to fill a space between the projection system and the substrate. An immersion liquid may also be applied to other spaces in the lithographic apparatus, for example, between the patterning device and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

During operation of the lithographic apparatus, a radiation beam is conditioned and provided by the illumination system IL. The radiation beam B is incident on the patterning device (e.g., mask) MA, which is held on the support structure (e.g., mask table) MT, and is patterned by the patterning device. Having traversed the patterning device MA, the radiation beam B passes through the projection system PS, which focuses the beam onto a target portion C of the substrate W. With the aid of the second positioner PW and position sensor IF (e.g. an interferometric device, linear encoder, 2-D encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the patterning device MA with respect to the path of the radiation beam B, e.g. after mechanical retrieval from a mask library, or during a scan. In general, movement of the support structure MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner), the support structure MT may be connected to a short-stroke actuator only, or may be fixed. Patterning device MA and substrate W may be aligned using patterning device alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device MA, the patterning device alignment marks may be located between the dies.

The depicted apparatus could be used in at least one of the following modes:

1. In step mode, the support structure MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.

2. In scan mode, the support structure MT and the substrate table WT are scanned synchronously while a pattern imparted to the radiation beam is projected onto a target portion C (i.e. a single dynamic exposure). The velocity and direction of the substrate table WT relative to the support structure MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion.

3. In another mode, the support structure MT is kept essentially stationary holding a programmable patterning device, and the substrate table WT is moved or scanned while a pattern imparted to the radiation beam is projected onto a target portion C. In this mode, generally, a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above-described modes of use or entirely different modes of use may also be employed.

Although specific reference may be made in this text to the use of lithography apparatus in the manufacture of ICs, it should be understood that the lithography apparatus described herein may have other applications, such as the manufacture of integrated optical systems, guidance and detection patterns for magnetic domain memories, liquid-crystal displays (LCDs), thin film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

Various patterns on or provided by a patterning device may have different process windows. i.e., a space of processing variables under which a pattern will be produced within specification. Examples of pattern specifications that relate to potential systematic defects include checks for necking, line-end pull back, line thinning, CD, edge placement, overlapping, resist top loss, resist undercut and/or bridging. The process window of all the patterns on a patterning device or an area thereof may be obtained by merging (e.g., overlapping) process windows of each individual pattern. The boundary of the process window of all the patterns contains boundaries of process windows of some of the individual patterns. In other words, these individual patterns limit the process window of all the patterns. These patterns can be referred to as "hot spots" or "process window limiting patterns (PWLPs)," which are used interchangeably herein. When controlling a part of a patterning process, it is possible and economical to focus on the hot spots. When the hot spots are not defective, it is most likely that not all the patterns are defective.

As shown in Figure 2, the lithographic apparatus LA may form part of a lithographic cell LC, also sometimes referred to a lithocell or cluster, which also includes apparatuses to perform pre- and post-exposure processes on a substrate. Conventionally these include one or more spin coaters SC to deposit one or more resist layers, one or more developers DE to develop exposed resist, one or more chill plates CH and/or one or more bake plates BK. A substrate handler, or robot, RO picks up one or more substrates from input/output port I/O1, I/O2, moves them between the different process apparatuses and delivers them to the loading bay LB of the lithographic apparatus. These apparatuses, which are often collectively referred to as the track, are under the control of a track control unit TCU which is itself controlled by the supervisory control system SCS, which also controls the lithographic apparatus via lithography control unit LACU. Thus, the different apparatuses can be operated to maximize throughput and processing efficiency.

In order to ensure that a substrate that is exposed by the lithographic apparatus is exposed correctly and consistently and/or in order to monitor a part of the patterning process (e.g., a device manufacturing process) that includes at least one pattern transfer step (e.g., an optical lithography step), it is desirable to inspect a substrate or other object to measure or determine one or more properties such as alignment, overlay (which can be, for example, between structures in overlying layers or between structures in a same layer that have been provided separately to the layer by, for example, a double patterning process), line thickness, critical dimension (CD), focus offset, a material property, etc. Accordingly, a manufacturing facility in which lithocell LC is located also typically includes a metrology system MET that measures some or all of the substrates W that have been processed in the lithocell or other objects in the lithocell. The metrology system MET may be part of the lithocell LC, for example, it may be part of the lithographic apparatus LA (such as alignment sensor AS).

The one or more measured parameters may include, for example, overlay between successive layers formed in or on the patterned substrate, critical dimension (CD) (e.g., critical linewidth) of, for example, features formed in or on the patterned substrate, focus or focus error of an optical lithography step, dose or dose error of an optical lithography step, optical aberrations of an optical lithography step, etc. This measurement may be performed on a target of the product substrate itself and/or on a dedicated metrology target provided on the substrate. The measurement can be performed after-development of a resist but before etching or can be performed after-etch.

There are various techniques for making measurements of the structures formed in the patterning process, including the use of a scanning electron microscope, an image-based measurement tool and/or various specialized tools. As discussed above, a fast and non-invasive form of specialized metrology tool is one in which a beam of radiation is directed onto a target on the surface of the substrate and properties of the scattered (diffracted/reflected) beam are measured. By evaluating one or more properties of the radiation scattered by the substrate, one or more properties of the substrate can be determined. This may be termed diffraction-based metrology. One such application of this diffraction-based metrology is in the measurement of feature asymmetry within a target. This can be used as a measure of overlay, for example, but other applications are also known. For example, asymmetry can be measured by comparing opposite parts of the diffraction spectrum (for example, comparing the -1st and +1st orders in the diffraction spectrum of a periodic grating). This can be done as described above and as described, for example, in U.S. patent application publication US 2006/066855, which is incorporated herein in its entirety by reference. Another application of diffraction-based metrology is in the measurement of feature width (CD) within a target. Such techniques can use the apparatus and methods described hereafter.

In a device fabrication process (e.g., a patterning process or a lithography process), a substrate or other objects may be subjected to various types of measurement during or after the process. The measurement may determine whether a particular substrate is defective, may establish adjustments to the process and apparatuses used in the process (e.g., aligning two layers on the substrate or aligning the patterning device to the substrate), may measure the performance of the process and the apparatuses, or may be for other purposes. Examples of measurement include optical imaging (e.g., optical microscope), non-imaging optical measurement (e.g., measurement based on diffraction such as ASML YieldStar metrology tool, ASML SMASH metrology system), mechanical measurement (e.g., profiling using a stylus, atomic force microscopy (AFM)), and/or non-optical imaging (e.g., scanning electron microscopy (SEM)). The SMASH (SMart Alignment Sensor Hybrid) system, as described in U.S. Pat. No. 6,961,116, which is incorporated by reference herein in its entirety, employs a self-referencing interferometer that produces two overlapping and relatively rotated images of an alignment marker, detects intensities in a pupil plane where Fourier transforms of the images are caused to interfere, and extracts the positional information from the phase difference between diffraction orders of the two images which manifests as intensity variations in the interfered orders.

Metrology results may be provided directly or indirectly to the supervisory control system SCS. If an error is detected, an adjustment may be made to exposure of a subsequent substrate (especially if the inspection can be done soon and fast enough that one or more other substrates of the batch are still to be exposed) and/or to subsequent exposure of the exposed substrate. In addition, an already exposed substrate may be stripped and reworked to improve yield, or discarded, thereby avoiding performing further processing on a substrate known to be faulty. In a case where only some target portions of a substrate are faulty, further exposures may be performed only on those target portions that are good.

Within a metrology system MET, a metrology apparatus is used to determine one or more properties of the substrate, and in particular, how one or more properties of different substrates vary or different layers of the same substrate vary from layer to layer. As noted above, the metrology apparatus may be integrated into the lithographic apparatus LA or the lithocell LC or may be a stand-alone device.

To enable the metrology, one or more targets can be provided on the substrate. In an embodiment, the target is specially designed and may comprise a periodic structure. In an embodiment, the target is a part of a device pattern, e.g., a periodic structure of the device pattern. In an embodiment, the device pattern is a periodic structure of a memory device (e.g., a Bipolar Transistor (BPT), a Bit Line Contact (BLC), etc. structure).

In an embodiment, the target on a substrate may comprise one or more 1-D periodic structures (e.g., gratings), which are printed such that after development, the periodic structural features are formed of solid resist lines. In an embodiment, the target may comprise one or more 2-D periodic structures (e.g., gratings), which are printed such that after development, the one or more periodic structures are formed of solid resist pillars or vias in the resist. The bars, pillars or vias may alternatively be etched into the substrate (e.g., into one or more layers on the substrate).

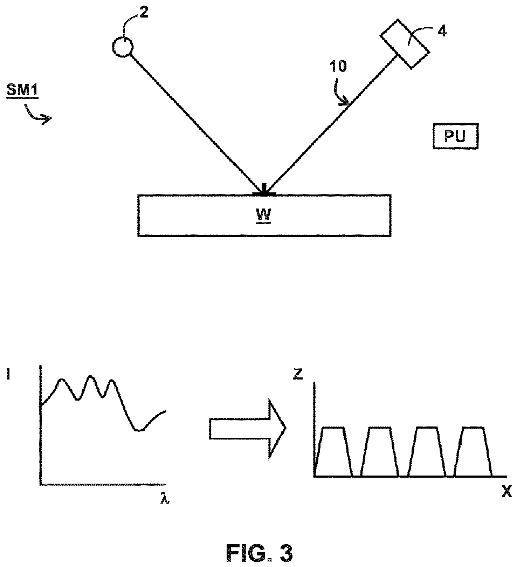

Figure 3 depicts an example inspection apparatus (e.g., a scatterometer). It comprises a broadband (white light) radiation projector 2 which projects radiation onto a substrate W. The redirected radiation is passed to a spectrometer detector 4, which measures a spectrum 10 (intensity as a function of wavelength) of the specular reflected radiation, as shown, e.g., in the graph in the lower left. From this data, the structure or profile giving rise to the detected spectrum may be reconstructed by processor PU, e.g. by Rigorous Coupled Wave Analysis and non-linear regression or by comparison with a library of simulated spectra as shown at the bottom right of Figure 3. The bottom right graph is a reconstructed profile corresponding to a spectrum graph illustrated at the bottom left. In general, for the reconstruction, the general form of the structure is known and some variables are assumed from knowledge of the process by which the structure was made, leaving only a few variables of the structure to be determined from the measured data. Such an inspection apparatus may be configured as a normal-incidence inspection apparatus or an oblique-incidence inspection apparatus.

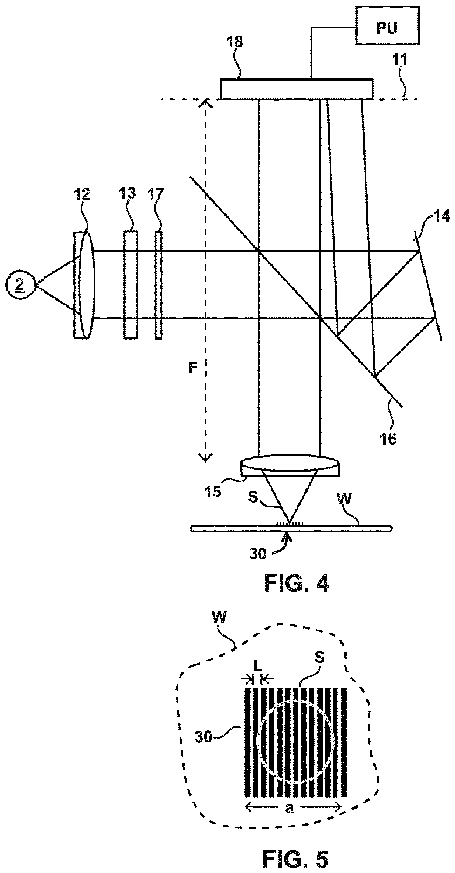

Another inspection apparatus that may be used is shown in Figure 4. In this device, the radiation emitted by radiation source 2 is collimated using lens system 12 and transmitted through interference filter 13 and polarizer 17, reflected by partially reflecting surface 16 and is focused into a spot S on substrate W via an objective lens 15, which has a high numerical aperture (NA), desirably at least 0.9 or at least 0.95. An immersion inspection apparatus (using a relatively high refractive index fluid such as water) may even have a numerical aperture over 1.

As in the lithographic apparatus LA, one or more substrate tables may be provided to hold the substrate W during measurement operations. The substrate tables may be similar or identical in form to the substrate table WT of Figure 1. In an example where the inspection apparatus is integrated with the lithographic apparatus, they may even be the same substrate table. Coarse and fine positioners may be provided to a second positioner PW configured to accurately position the substrate in relation to a measurement optical system. Various sensors and actuators are provided for example to acquire the position of a target of interest, and to bring it into position under the objective lens 15. Typically, many measurements will be made on targets at different locations across the substrate W. The substrate support can be moved in X and Y directions to acquire different targets, and in the Z direction to obtain a desired location of the target relative to the focus of the optical system. It is convenient to think and describe operations as if the objective lens is being brought to different locations relative to the substrate, when, for example, in practice the optical system may remain substantially stationary (typically in the X and Y directions, but perhaps also in the Z direction) and only the substrate moves. Provided the relative position of the substrate and the optical system is correct, it does not matter in principle which one of those is moving in the real world, or if both are moving, or a combination of a part of the optical system is moving (e.g., in the Z and/or tilt direction) with the remainder of the optical system being stationary and the substrate is moving (e.g., in the X and Y directions, but also optionally in the Z and/or tilt direction).

The radiation redirected by the substrate W then passes through partially reflecting surface 16 into a detector 18 in order to have the spectrum detected. The detector 18 may be located at a back-projected focal plane 11 (i.e., at the focal length of the lens system 15) or the plane 11 may be re-imaged with auxiliary optics (not shown) onto the detector 18. The detector may be a two-dimensional detector so that a two-dimensional angular scatter spectrum of a substrate target 30 can be measured. The detector 18 may be, for example, an array of CCD or CMOS sensors, and may use an integration time of, for example, 40 milliseconds per frame.

A reference beam may be used, for example, to measure the intensity of the incident radiation. To do this, when the radiation beam is incident on the partially reflecting surface 16 part of it is transmitted through the partially reflecting surface 16 as a reference beam towards a reference mirror 14. The reference beam is then projected onto a different part of the same detector 18 or alternatively on to a different detector (not shown).

One or more interference filters 13 are available to select a wavelength of interest in the range of, say, 405 - 790 nm or even lower, such as 200 - 300 nm. The interference filter may be tunable rather than comprising a set of different filters. A grating could be used instead of an interference filter. An aperture stop or spatial light modulator (not shown) may be provided in the illumination path to control the range of angle of incidence of radiation on the target.

The detector 18 may measure the intensity of redirected radiation at a single wavelength (or narrow wavelength range), the intensity separately at multiple wavelengths or integrated over a wavelength range. Furthermore, the detector may separately measure the intensity of transverse magnetic- and transverse electric-polarized radiation and/or the phase difference between the transverse magnetic- and transverse electric-polarized radiation.

The target 30 on substrate W may be a 1-D grating, which is printed such that after development, the bars are formed of solid resist lines. The target 30 may be a 2-D grating, which is printed such that after development, the grating is formed of solid resist pillars or vias in the resist. The bars, pillars or vias may be etched into or on the substrate (e.g., into one or more layers on the substrate). The pattern (e.g., of bars, pillars or vias) is sensitive to change in processing in the patterning process (e.g., optical aberration in the lithographic projection apparatus (particularly the projection system PS, focus change, dose change, etc.) and will manifest in a variation in the printed grating. Accordingly, the measured data of the printed grating is used to reconstruct the grating. One or more parameters of the 1-D grating, such as line width and/or shape, or one or more parameters of the 2-D grating, such as pillar or via width or length or shape, may be input to the reconstruction process, performed by processor PU, from knowledge of the printing step and/or other inspection processes.

In addition to measurement of a parameter by reconstruction, angle resolved scatterometry is useful in the measurement of asymmetry of features in product and/or resist patterns. A particular application of asymmetry measurement is for the measurement of overlay, where the target 30 comprises one set of periodic features superimposed on another. The concepts of asymmetry measurement using the instrument of Figure 3 or Figure 4 are described, for example, in U.S. patent application publication US2006-066855, which is incorporated herein in its entirety. Simply stated, while the positions of the diffraction orders in the diffraction spectrum of the target are determined only by the periodicity of the target, asymmetry in the diffraction spectrum is indicative of asymmetry in the individual features that make up the target. In the instrument of Figure 4, where detector 18 may be an image sensor, such asymmetry in the diffraction orders appears directly as asymmetry in the pupil image recorded by detector 18. This asymmetry can be measured by digital image processing in unit PU, and calibrated against known values of overlay.

Figure 5 illustrates a plane view of a typical target 30, and the extent of illumination spot S in the apparatus of Figure 4. To obtain a diffraction spectrum that is free of interference from surrounding structures, the target 30, in an embodiment, is a periodic structure (e.g., grating) larger than the width (e.g., diameter) of the illumination spot S. The width of spot S may be smaller than the width and length of the target. The target in other words is 'underfilled' by the illumination, and the diffraction signal is essentially free from any signals from product features and the like outside the target itself. The illumination arrangement 2, 12, 13, 17 may be configured to provide illumination of a uniform intensity across a back focal plane of objective 15. Alternatively, by, e.g., including an aperture in the illumination path, illumination may be restricted to on axis or off axis directions.

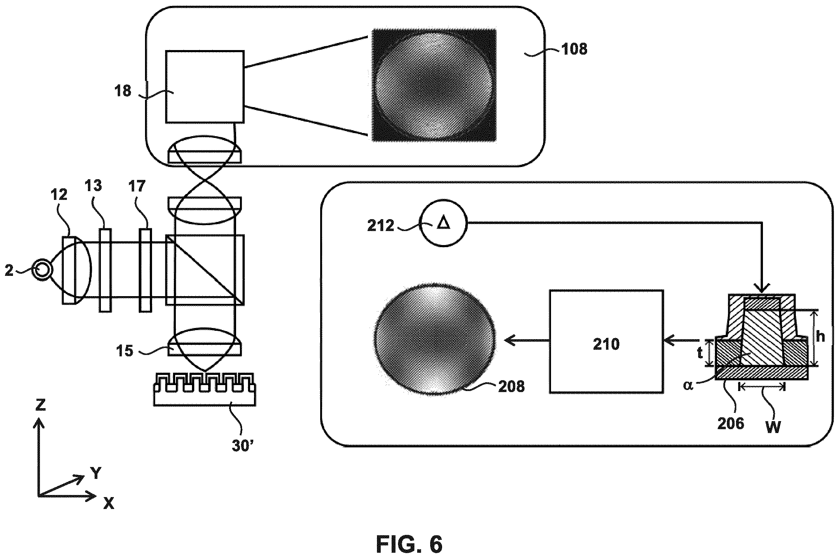

Figure 6 schematically depicts an example process of the determination of the value of one or more variables of interest of a target pattern 30' based on measurement data obtained using metrology. Radiation detected by the detector 18 provides a measured radiation distribution 108 for target 30'.

For a given target 30', a radiation distribution 208 can be computed / simulated from a parameterized model 206 using, for example, a numerical Maxwell solver 210. The parameterized model 206 shows example layers of various materials making up, and associated with, the target. The parameterized model 206 may include one or more of variables for the features and layers of the portion of the target under consideration, which may be varied and derived. As shown in Figure 6, the one or more of the variables may include the thickness t of one or more layers, a width w (e.g., CD) of one or more features, a height h of one or more features, and/or a sidewall angle α of one or more features. Although not shown, the one or more of the variables may further include, but is not limited to, the refractive index (e.g., a real or complex refractive index, refractive index tensor, etc.) of one or more of the layers, the extinction coefficient of one or more layers, the absorption of one or more layers, resist loss during development, a footing of one or more features, and/or line edge roughness of one or more features. The initial values of the variables may be those expected for the target being measured. The measured radiation distribution 108 is then compared at 212 to the computed radiation distribution 208 to determine the difference between the two. If there is a difference, the values of one or more of the variables of the parameterized model 206 may be varied, a new computed radiation distribution 208 calculated and compared against the measured radiation distribution 108 until there is sufficient match between the measured radiation distribution 108 and the computed radiation distribution 208. At that point, the values of the variables of the parameterized model 206 provide a good or best match of the geometry of the actual target 30'. In an embodiment, there is sufficient match when a difference between the measured radiation distribution 108 and the computed radiation distribution 208 is within a tolerance threshold.

As semiconductor or other device manufacturing processes continue to advance, the dimensions of functional elements have continually been reduced while the amount of functional elements, such as transistors, per device has been steadily increasing over decades, following a trend commonly referred to as "Moore's law". At the current state of technology, layers of devices are manufactured using lithographic apparatuses that project a design layout onto a substrate using illumination from a deep-ultraviolet (e.g., 193 nm) illumination source or an extreme-ultraviolet (e.g., 13.52 nm) illumination source, creating individual functional elements having dimensions well below 30 nm.

This process in which features with dimensions smaller than the classical resolution limit of a lithographic apparatus are printed, is commonly known as low-kl lithography, according to the resolution formula CD = k1×λ/NA, where λ is the wavelength of radiation employed (currently in most cases 248nm or 193nm), NA is the numerical aperture of projection optics in the lithographic apparatus, CD is the "critical dimension"-generally the smallest feature size printed-and k1 is an empirical resolution factor. In general, the smaller k1 the more difficult it becomes to reproduce a pattern on the substrate that resembles the shape and dimensions planned by a circuit designer in order to achieve particular electrical functionality and performance. To overcome these difficulties, sophisticated fine-tuning steps are applied to the lithographic apparatus or the design layout. These include, for example, but not limited to, optimization of NA and optical coherence settings, customized illumination schemes, use of phase shifting patterning devices, optical proximity correction (OPC) in the design layout, or other methods generally defined as "resolution enhancement techniques" (RET).

As an example of RET, OPC addresses the fact that the final size and placement of an image of the design layout projected on the substrate will not be identical to, or simply depend only on the size and placement of the design layout on the patterning device. As described above, the terms "mask", "reticle", and/or "patterning device" are utilized interchangeably herein. Also, person skilled in the art will recognize that, the term "mask," "patterning device" and "design layout" can be used interchangeably, as in the context of RET, a physical patterning device is not necessarily used but a design layout can be used to represent a physical patterning device. For the small feature sizes and high feature densities present on some design layout, the position of a particular edge of a given feature will be influenced to a certain extent by the presence or absence of other adjacent features. These proximity effects arise from minute amounts of radiation coupled from one feature to another or non-geometrical optical effects such as diffraction and interference. Similarly, proximity effects may arise from diffusion and other chemical effects during post-exposure bake (PEB), resist development, and etching that generally follow lithography.

In order to increase the chance that the projected image of the design layout is in accordance with requirements of a given target circuit design, proximity effects may be predicted and compensated for, using sophisticated numerical models, corrections or pre-distortions of the design layout. The article "Full-Chip Lithography Simulation and Design Analysis - How OPC Is Changing IC Design", C. Spence, Proc. SPIE, Vol. 5751, pp 1-14 (2005) provides an overview of current "model-based" optical proximity correction processes. In a typical high-end design, almost every feature of the design layout has some modification in order to achieve high fidelity of the projected image to the target design. These modifications may include shifting or biasing of edge positions or line widths as well as application of "assist" features that are intended to assist projection of other features.

One of the simplest forms of OPC is selective bias. Given a CD vs. pitch curve, all of the different pitches could be forced to produce the same CD, at least at best focus and exposure, by changing the CD at the patterning device level. Thus, if a feature prints too small at the substrate level, the patterning device level feature would be biased to be slightly larger than nominal, and vice versa. Since the pattern transfer process from patterning device level to substrate level is non-linear, the amount of bias is not simply the measured CD error at best focus and exposure times the reduction ratio, but with modeling and experimentation an appropriate bias can be determined. Selective bias is an incomplete solution to the problem of proximity effects, particularly if it is only applied at the nominal process condition. Even though such bias could, in principle, be applied to give uniform CD versus pitch curves at best focus and exposure, once the exposure process varies from the nominal condition, each biased pitch curve will respond differently, resulting in different process windows for the different features. A process window being a range of values of two or more process parameters (e.g., focus and radiation dose in the lithographic apparatus) under which a feature is sufficiently properly created (e.g., the CD of the feature is within a certain range such as ±10% or ±5%). Therefore, the "best" bias to give identical CD vs. pitch may even have a negative impact on the overall process window, reducing rather than enlarging the focus and exposure range within which all of the target features print on the substrate within the desired process tolerance.

Other more complex OPC techniques have been developed for application beyond the one-dimensional bias example above. A two-dimensional proximity effect is line end shortening. Line ends have a tendency to "pull back" from their desired end point location as a function of exposure and focus. In many cases, the degree of end shortening of a long line end can be several times larger than the corresponding line narrowing. This type of line end pull back can result in catastrophic failure of the devices being manufactured if the line end fails to completely cross over the underlying layer it was intended to cover, such as a polysilicon gate layer over a source-drain region. Since this type of pattern is highly sensitive to focus and exposure, simply biasing the line end to be longer than the design length is inadequate because the line at best focus and exposure, or in an underexposed condition, would be excessively long, resulting either in short circuits as the extended line end touches neighboring structures, or unnecessarily large circuit sizes if more space is added between individual features in the circuit. Since one of the goals of integrated circuit design and manufacturing is to maximize the number of functional elements while minimizing the area required per chip, adding excess spacing is an undesirable solution.

Two-dimensional OPC approaches may help solve the line end pull back problem. Extra structures (also known as "assist features") such as "hammerheads" or "serifs" may be added to line ends to effectively anchor them in place and provide reduced pull back over the entire process window. Even at best focus and exposure these extra structures are not resolved but they alter the appearance of the main feature without being fully resolved on their own. A "main feature" as used herein means a feature intended to print on a substrate under some or all conditions in the process window. Assist features can take on much more aggressive forms than simple hammerheads added to line ends, to the extent the pattern on the patterning device is no longer simply the desired substrate pattern upsized by the reduction ratio. Assist features such as serifs can be applied for many more situations than simply reducing line end pull back. Inner or outer serifs can be applied to any edge, especially two dimensional edges, to reduce corner rounding or edge extrusions. With enough selective biasing and assist features of all sizes and polarities, the features on the patterning device bear less and less of a resemblance to the final pattern desired at the substrate level. In general, the patterning device pattern becomes a pre-distorted version of the substrate-level pattern, where the distortion is intended to counteract or reverse the pattern deformation that will occur during the manufacturing process to produce a pattern on the substrate that is as close to the one intended by the designer as possible.

Another OPC technique involves using completely independent and non-resolvable assist features, instead of or in addition to those assist features (e.g., serifs) connected to the main features. The term "independent" here means that edges of these assist features are not connected to edges of the main features. These independent assist features are not intended or desired to print as features on the substrate, but rather are intended to modify the aerial image of a nearby main feature to enhance the printability and process tolerance of that main feature. These assist features (often referred to as "scattering bars" or "SBAR") can include sub-resolution assist features (SRAF) which are features outside edges of the main features and sub-resolution inverse features (SRIF) which are features scooped out from inside the edges of the main features. The presence of a SBAR adds yet another layer of complexity to a patterning device pattern. A simple example of a use of scattering bars is where a regular array of non-resolvable scattering bars is drawn on both sides of an isolated line feature, which has the effect of making the isolated line appear, from an aerial image standpoint, to be more representative of a single line within an array of dense lines, resulting in a process window much closer in focus and exposure tolerance to that of a dense pattern. The common process window between such a decorated isolated feature and a dense pattern will have a larger common tolerance to focus and exposure variations than that of a feature drawn as isolated at the patterning device level.

An assist feature may be viewed as a difference between features on a patterning device and features in the design layout. The terms "main feature" and "assist feature" do not imply that a particular feature on a patterning device must be labeled as one or the other.

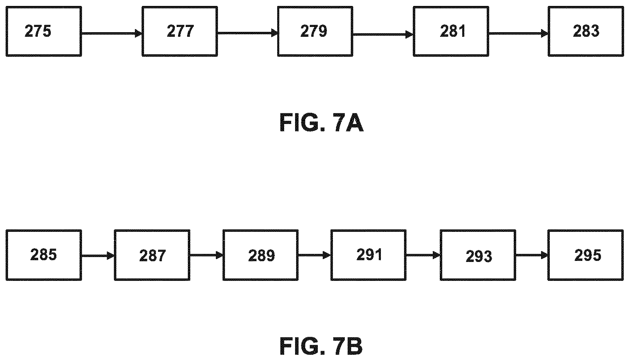

Fig. 7A shows a flowchart that lists the main stages of a "design for control" (D4C) method. In stage 275, the materials to be used in the lithography process are selected. The materials may be selected from a materials library interfaced with D4C through an appropriate GUI. In stage 277, a lithography process is defined by entering each of the process steps, and building a computer simulation model for the entire process sequence. In stage 279, a metrology target is defined, i.e. dimensions and other characteristics of various features included in the target are entered into the D4C program. For example, if a grating is included in a structure, then number of grating elements, width of individual grating elements, spacing between two grating elements etc. have to be defined. In stage 281, the 3D geometry is created. This step also takes into account whether there is any information relevant to a multi-layer target design, for example, the relative shifts between different layers. This feature enables multi-layer target design. In stage 283, the final geometry of the designed target is visualized. As will be explained in greater detail below, not only the final design is visualized, but as the designer applies various steps of the lithography process (e.g., chemical mechanical polishing), he/she can visualize how the 3D geometry is being formed and changed because of process-induced effects. For example, the 3D geometry after resist patterning is different from the 3D geometry after resist removal and etching and/or chemical mechanical polishing.

An important aspect of the present disclosure is that the target designer is enabled to visualize the stages of the method to facilitate their perception and control during modeling and simulation. Different visualization tools, referred to as "viewers," are built into the D4C software. For example, as shown in Figure 7B, a designer can view material plots 285 (and may also get a run time estimation plot) depending on the defined lithography process and target. Once the lithography model is created, the designer can view the model parameters through model viewer tool 287. Design layout viewer tool 289 may be used to view the design layout (e.g., visual rendering of the GDS file). Resist profile viewer tool 291 may be used to view pattern profiles in a resist. Geometry viewer tool 293 may be used to view 3D structures on a substrate. A pupil viewer tool 295 may be used to view simulated response on a metrology tool. Persons skilled in the art would understand that these viewing tools are available to enhance the understanding of the designer during design and simulation. One or more of these tools may not be present in some embodiments of D4C software, and additional viewing tools may be there in some other embodiments.

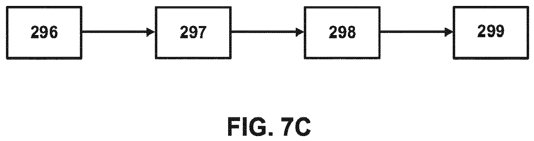

Figure 7C shows a flow chart that illustrates how the D4C process increases efficiency in the overall simulation process by reducing the number of metrology targets selected for the actual simulation of the lithography process. As mentioned before, D4C enables designers to design thousands or even millions of designs. Not all of these designs may be robust against variations in the process steps. To select a subset of target designs that can withstand process variation, a lithographer may intentionally perturb one or more steps of the defined lithography process, as shown in block 296. The introduction of the perturbation alters the entire process sequence with respect to how it was originally defined. Therefore, applying the perturbed process sequence (block 297) alters the 3D geometry of the designed target too. A lithographer only selects the perturbations that show nonzero alternations in the original design targets and creates a subset of selected process perturbations (block 298). The lithography process is then simulated with this subset of process perturbations (block 299).

The manufacturing or fabrication of a substrate using the lithographic process (or patterning process in general) typically involves process variations. The process variations are not uniform across the substrate. For example, in chemical mechanical polishing, contact forces and friction are not uniform across a wafer. These systematic variations are often reflected in measurement data as 'fingerprints', which are characteristics of a substrate based on known process conditions. In other words, there exists a stack on a substrate that has a spatial variation as a function of substrate coordinate. A stack comprises multiple layers formed on a substrate during the patterning process to form a selected pattern (e.g., a design pattern) on the substrate. Each layer of the stack can be associated with a thickness, material properties, and features and related parameters of the patterning process (e.g. CD, pitch, overlay, etc.).

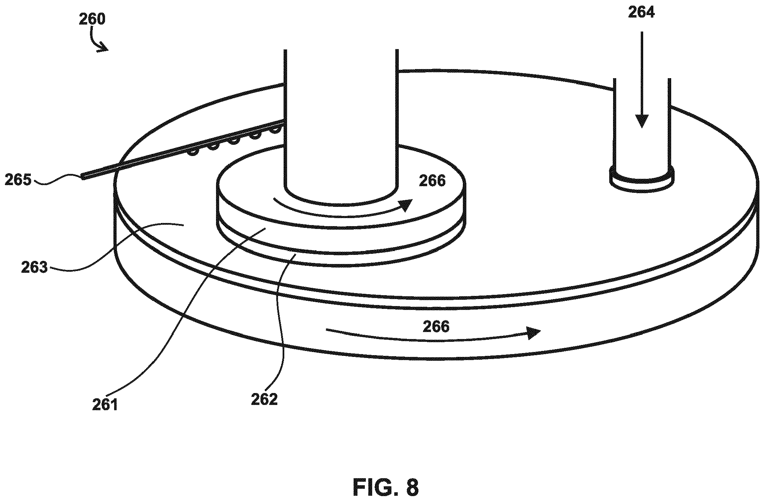

Process asymmetry during chemical mechanical polishing is a known phenomenon in the semiconductor manufacturing business. This process asymmetry may lead to errors in alignment and overlay measurements, for example. In semiconductor manufacturing, chemical mechanical polishing is used to smooth a surface of a wafer (and/or other substrates), to expose underlying structures on a substrate, or to remove excess materials from a substrate. The smoothing is performed using a combination of chemical and mechanical forces. A typical chemical mechanical polishing apparatus 260 is illustrated in Figure 8. As shown in Figure 8, chemical mechanical polishing apparatus 260 includes a wafer carrier 261 configured to carry a wafer 262, a polishing pad 263, a pad conditioner 264, and a slurry dispenser 265. Wafer carrier 261 holds wafer 262 against or nearly against pad 263 as pad 263 and wafer carrier 261 rotate. Pad 263 and wafer carrier 261 rotate the same direction 266, but at different rotational velocities. An abrasive and corrosive slurry is dispensed from slurry dispenser 265. The slurry and pad 263 polish wafer 262 as pad 263 and wafer carrier 261 rotate.

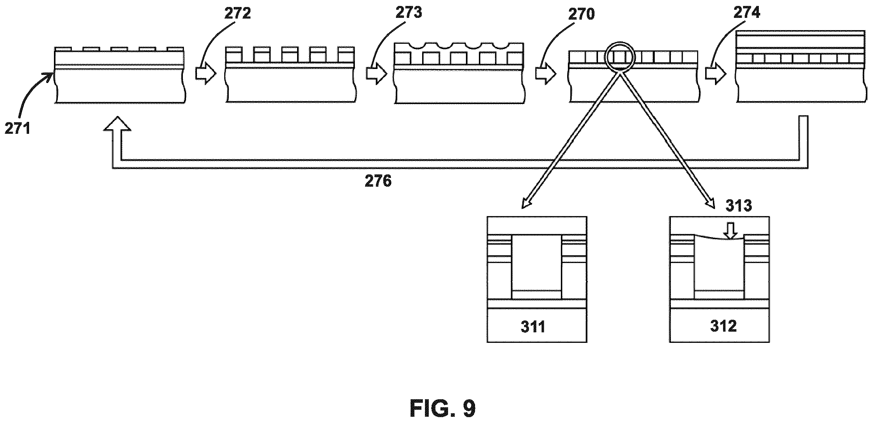

Figure 9 is a cross-sectional illustration of chemical mechanical polishing 270 performed on a wafer 271 as part of a semiconductor manufacturing process. Figure 9 illustrates a cross section of an alignment mark made with a simplified (relative to a typical semiconductor manufacturing process) manufacturing flow. Chemical mechanical polishing 270 is preceded by etch 272 and deposition 273, and followed by coating(s) 274 in the semiconductor manufacturing process shown in Figure 9. After coating 274, the alignment mark is used to align the next layer of the wafer and the process is repeated 276. Figure 9 illustrates example unit cell of a target 311 and 312 with surface topographies for wafer 271 after chemical mechanical polishing 270. Often, surface topography irregularities 313 cause an asymmetric grating structure in optical alignment marks (for example) which produce biased readings in optical measurements.

Current commercial technical computer aided design (TCAD) and electronic design automation (EDA) products assume a geometric shape and use a small number of geometric parameters to model chemical mechanical polishing process asymmetry. However, these types of models lack a sufficient basis in processing physics to properly predict asymmetry on a wafer that occurs because of chemical mechanical polishing. In contrast to prior art systems, the present methods (and systems) provide a physics-based chemical mechanical polishing predictive solution for metrology target design, sensor metrology correction, and/or for other purposes. For example, grating asymmetry produced in chemical mechanical polishing can lead to errors in overlay and alignment measurements. The methods and systems described herein provide a solution for predicting the influence of chemical mechanical polishing.

The present methods and systems model a chemical mechanical polishing process to predict and/or otherwise determine geometric information of metrology and/or other structures on a wafer at any stage during chemical mechanical polishing, or after chemical mechanical polishing. The modelling is based on a wafer surface profile before chemical mechanical polishing, surface and mechanical properties of a polishing pad, down force between the wafer and the pad during chemical mechanical polishing, polishing endpoint condition, quantification of the movement of the polishing pad and the wafer during chemical mechanical polishing, slurry characteristics and selectivity, and/or other information (e.g., as described herein). A prediction combined with optical simulations can work as a feedforward control for chip design, OPC, and metrology correction, for example.

The paragraphs below describe aspects of one or more methods used for the prediction of post- chemical mechanical polishing wafer surface topography, or an intermediate surface topography during an ongoing chemical mechanical polishing. The method combines wafer load distribution determinations, kinematic analysis of the chemical mechanical polishing process, contact mechanics analysis, and/or other operations. Among other advantages, using the present method, grating asymmetry in chemical mechanical polishing is explained and linked to physical process parameters.

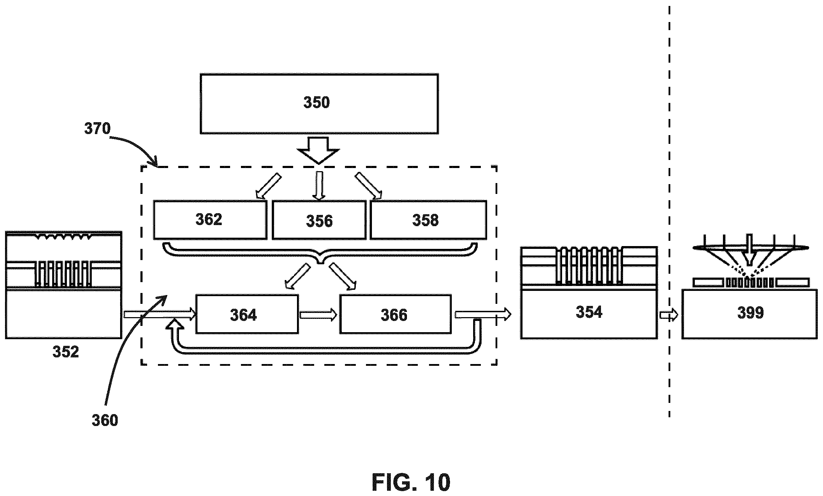

Figure 10 is a schematic illustration of one embodiment of the present method. Figure 10 illustrates various operations that are performed by the present system(s) and/or are part of the present method(s). As shown in Figure 10, these operations include receiving physical parameters 350, receiving input geometry 352, and determining output geometry 354. The operations also include determining load distribution information 356, kinematic information 358, contact mechanics information 360 (which includes determining an initial influential coefficient matrix 362 and a pressure profile 364 across a wafer), material removal information 366, and/or other information.

Together, determining load distribution information 356, kinematic information 358, contact mechanics information 360, and material removal information 366 may be thought of as a physical model 370 of a chemical mechanical polishing process, and/or a profile generator configured to predict and/or otherwise determine chemical mechanical polishing output wafer geometry (e.g., output geometry 354), for example. These determinations may correspond to individual modules, for example, of model 370. The modules may include an influential coefficient matrix generator (e.g., corresponding to determining contact mechanics information 360) configured to produce kernel functions for a contact mechanics pressure solver. The modules may include an asperity load generator (e.g., corresponding to determining load distribution information 356) configured to treat wafer-pad contact as a discontinuous contact between wafer and pad asperities, with a surface roughness factor of the pad used for determining how a total downforce is distributed on individual asperities. The modules may include a kinematic analysis module (e.g., corresponding to determining kinematic information 358) configured to consider rotation motion of the wafer carrier and pad platen during chemical mechanical polishing. The modules may include a contact mechanics pressure solver (e.g., corresponding to determining contact mechanics information 360) configured to predict contact pressures across the wafer based on a surface topography of the wafer and/or other information. The modules may include a profile iterator (e.g., corresponding to determining material removal information 366) configured to update (an as received) surface profile (e.g., input geometry 352) based on the pressure distribution determined by the contact mechanics pressure solver, Preston's equation, and/or other information, for example. These determinations and/or modules are further described below.

Physical parameters 350 are associated with the wafer, the pad, a simulated chemical mechanical polishing process, and/or other portions of a chemical mechanical polishing process. Receiving physical parameters 350 may include electronically obtaining the physical parameters from an electronic database, for example, and/or other locations; receiving entry and/or selection of the physical parameters through a user interface; and/or other operations. In some embodiments, physical parameters 350 comprise one or more of an elastic or dynamic modulus of the pad, a Poisson ratio for the pad, a pad asperity model, a pad asperity height distribution curve, a pad asperity tip radius distribution curve, a pad asperity density, an elastic modulus of the wafer, a Poisson ratio for the wafer, a polishing speed constant, a friction coefficient, a pad rotation speed, a wafer rotation speed, a distance (e.g., center to center) between the wafer and the pad, Preston's constants related to a simulated polishing slurry in polishing for the appropriate materials, and/or other parameters. As described below, load distribution information 356, kinematic information 358, contact mechanics information 360, material removal information 366, and/or other information is determined based on physical parameters 350.

Input geometry 352 comprises geometric parameters associated with the wafer. Receiving input geometry 352 may include electronically obtaining the geometric parameters from an electronic database, for example, and/or other locations; receiving entry and/or selection of the geometric parameters through a user interface, and/or other operations. In some embodiments, the geometric parameters associated with the wafer include one or more of a pre-chemical mechanical polishing surface topography, parameters related to materials in a wafer stack of the wafer, a wafer stack height map, wafer stack thicknesses, coordinates of one or more locations on the wafer, and/or other information. In some embodiments, input geometry 352 may be received by way of a geometric description of a mesh based data file that includes geometric information for individual layers and materials in a stack. This information may also include, for example, the coordinates of an alignment mark or other periodic structure with respect to the center of the wafer.

As described herein, the post chemical mechanical polishing surface topography of the wafer may be predicted and/or otherwise determined based on the load distribution information 356, the kinematic information 358, the contact mechanics information 360, physical parameters 350, the geometric parameters associated with the wafer, and/or other information. In some embodiments, predicting and/or otherwise determining the post chemical mechanical polishing surface topography may comprise adjusting one or more of the pre-chemical mechanical polishing surface topography, the wafer stack height map, and/or other parameters, for example.

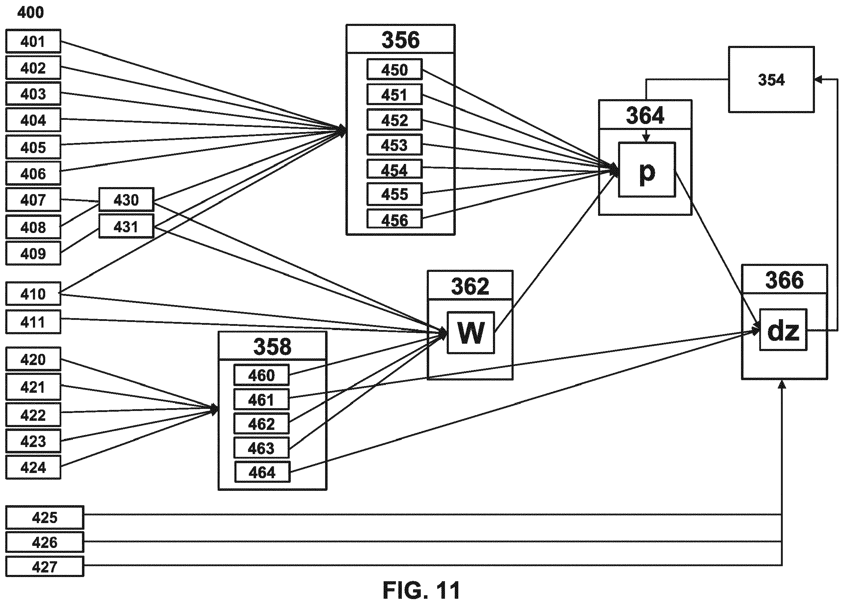

In some embodiments, one or more individual physical parameters 350 and/or input geometry 352 parameters may be used for one or more of determining load distribution information 356, kinematic information 358, contact mechanics information 360 (e.g., including determining influential coefficient matrix 362 and pressure profile 364 across a wafer), material removal information 366, and/or other information. For example, Figure 11 illustrates several combinations of input parameters 400 used to calculate load distribution information 356, kinematics information 358, influential coefficient matrix 362, material removal information 366, and/or other information. Input parameters 400 may include physical parameters 350, input geometry 352 parameters, and/or other parameters. In the example shown in Figure 11, input parameters 400 include a pad asperity model 401, a nominal down force 402, an integer number 403 which discretizes asperity load curve under the nominal down force 402 into discrete load values, a characteristic length of asperity height distribution 404, an nominal radius of asperities 405, a pad asperity number density per unit area 406, an elastic modulus of pad 407, a pad Poisson ratio 408, a linear viscoelastic constant of pad 409, a grid vector 410 that discretizes the wafer plane's Cartesian coordinates, a coefficient that translates tangential stress into normal stress 411, a rotation speed 420 of polishing pad 263, a rotation speed 421 or wafer carrier 261, a distance (e.g. center to center) 422 between pad and wafer carrier, an integer number 423 which discretizes polishing motion into a number of linear polishing motions towards discrete angles, a Cartesian coordinate 424 of a structure on a substrate (e.g. optical alignment mark) on a wafer plane, slurry constants 425, a process endpoint 426 (for example, fixed polishing time, stop on a layer and overpolish, and others), and a material removal rate model 427, but this example is not intended to be limiting. In some embodiments, intermediate parameters 430 and 431 may be determined and used with and/or instead of parameters 401-426 to determine load distribution information 356, kinematic information 358, contact mechanics information 360 (e.g., including determining influential coefficient matrix 362 and pressure profile 364 across a wafer), material removal information 366, and/or other information. As shown in Figure 11, intermediate parameter 430 (determined based on parameters 407 and 408 and used to determine load distribution information 356) is an effective elastic modulus, intermediate parameter 431 (determined based on parameters 409 and used to determine load distribution information 356) is a dynamic modulus of polishing pad, but this example is not intended to be limiting.

Figure 11 also illustrates determined parameters that are part of load distribution information 356 and kinematic information 358 (both of which are further described below). For example, discretized load values on individual asperities 450, probability of finding an asperity bearing the load corresponding to the load values 451, a nominal separation distance between polishing pad and wafer 452, a normalizing factor for asperity load distribution 453, an area of the structure (e.g. an alignment mark, a repeated unit cell as a part of a periodic structure) on substrate 454, a count on the number of asperities 455 on area 454, a nominal contact pressure 456 on area 454, and/or other parameters may be determined as part of determining load distribution information 356. As another example, discretized angles of the polishing motion 460, discretized scalar velocities of the polishing motion 461, an effective asymmetric polishing angle 462, an asymmetric polishing factor 463, an effective asymmetric polishing speed 464 at the angle 462, and/or other parameters may be determined as part of determining kinematic information 358. These examples are not intended to be limiting.

Returning to Figure 10, load distribution on individual asperities information 356 is indicative of possible forces between the wafer and the pad, and the probability of finding those forces during the chemical mechanical polishing. Load distribution on individual asperities information 356 is determined based on asperity loading functions of the pad and/or other information. In some embodiments, the asperity loading function of the pad is determined based on a pad asperity model, for example, a flat-tip model, or a round-tip model, and a number of parameters that characterize the model, for example, an average radius 405 and a characteristic height of the asperities 404, and/or other information. These examples are not intended to be limiting. Load distribution information 356 comprises a number of load values where asperity loads are discretized.

In some embodiments, determining load distribution information 356 comprises treating wafer-pad contact force as a weighted sum of wafer-pad contact forces 450, each at a probability of occurrence 451. The exact probability of occurrence at a defined contact force can be given directly as inputs to substitute one or more input parameters in 400, or derived from one or more input parameters in 400. In the latter case, surface roughness indicators of the pad (e.g., 404, 405) may be used to determine how a total downforce is distributed on individual asperities and the probability 451 of finding an asperity that contacts wafer at a given contact force 450. In some embodiments, determining load distribution information 356 may include receiving (e.g., as an input parameter described above) and/or determining a pad model that indicates an asperity loading function and/or other information. A non-limiting example of such a loading function is given in the following paragraph.

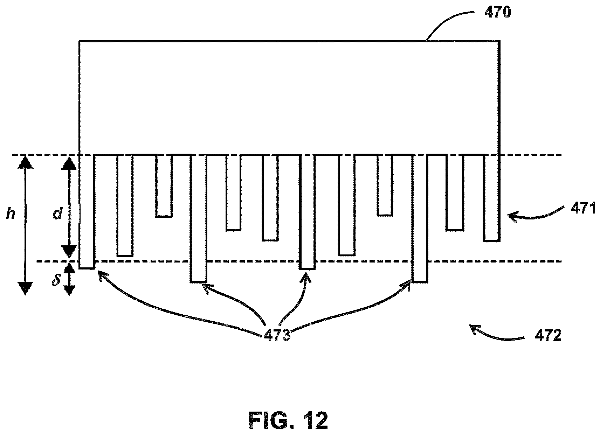

By way of a non-limiting example, Figure 12 illustrates a hypothetical far field pad bulk 470, pad asperities 471, and a wafer surface 472. Height "H" represents an amount an individual asperity 471 extends from pad bulk 470. Distance "d" represents a distance between pad bulk 470 and wafer surface 472. As shown in Figure 11 by distance "δ", some asperities 473 are longer than distance d and create discrete (and different) loads across wafer surface 472. The load (contact force) on such an asperity is treated as an explicit function of (δ - d), termed as an asperity loading function. The functional form of an asperity loading function is determined by pad asperity model 401. For example, a flat-tip Hooke's law model assumes a linear relation between load and (δ - d), a round-tip Hertzian contact model assumes a semicubic relation between load and (δ - d). These examples are not intended to be limiting.

Returning to Figure 10, kinematic information 358 comprises one or more parameters related to motion of the wafer and the pad during the chemical mechanical polishing. In some embodiments, one of the one or more parameters related to the motion of the wafer and the pad is an integer number 423 to discretize polishing directions. In some embodiments, the number of polishing directions is adjustable. The number of polishing directions may be adjusted, for example, via entries and/or selections may through a graphical and/or other user interface, and/or by other methods. During the polishing process, a structure on a substrate (e.g. alignment mark) is polished continuously in all directions with potential different speeds in wafer frame of reference. In some embodiments, an integer number 423 is used to discretize the continuous polishing motion into a number of polishing directions 460, each having a scalar polishing velocity 461. In such embodiments, the discretized angles 460 are used to determine influential coefficient matrix 362 and the discretized velocities 461 are used to determine material removal information 366. In some other embodiments, the continuous polishing motion is not discretized. Instead, an effective asymmetric polishing angle 462, an effective asymmetric factor 463 which scales coefficient 411 (for determining 462), and an effective asymmetric polishing velocity 464 are used to determine influential coefficient matrix 362 and material removal information 366. The effective parameters (e.g. 462 - 464) are intended to reduce computation time by eliminating the iterative calculation on pressure profiles 364 while generating comparable output structure 354.

Chemical mechanical polishing is a rotational process. Wafer asymmetry may be reduced if the pad and wafer rotate at the same speed during chemical mechanical polishing. However, for defect reduction reasons, the rotation speeds are typically different. This difference creates unbalanced polishing motion. In some embodiments, kinematic information 358 comprises one or more parameters indicative of the unbalanced polishing motion typically created during chemical mechanical polishing. These parameters (460-464) may be given as inputs to substitute one or more parameters in 420 - 424, or derived from one or more parameters in 420 - 424. In the latter case, the unbalanced polishing motion is reflected in angle dependent scalar polishing velocities 461, or an effective asymmetric factor 463.

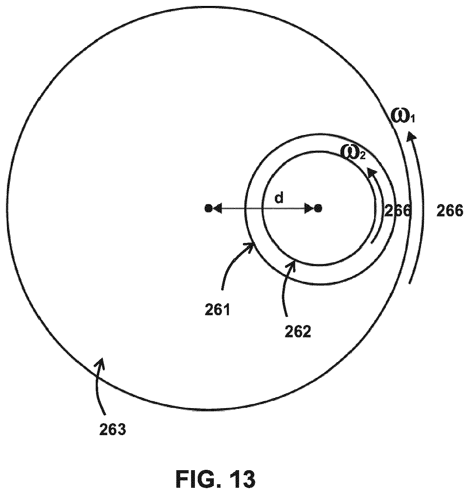

By way of a non-limiting example, Figure 13 illustrates wafer 262 and pad 263 (see Figure 8) rotating 266 relative to each other. As shown in Figure 13, pad 263 rotates at a first angular velocity $\omega_1$, and wafer 262 rotates at a second angular velocity $\omega_2$. Figure 13 also illustrates wafer carrier 261 and a center-to-center distance d between the centers of wafer 262 and pad 263. The angular velocities, the center-to-center distance, and/or other parameters of the chemical mechanical polishing process may be included in the physical parameters described above, for example.

Returning to Figure 10, contact mechanics information 360 is indicative of contact pressure profiles between a structure on a wafer substrate and a pad during chemical mechanical polishing at one or a plurality of locations across the wafer. The contact pressures, dependent on the unbalanced polishing motion (e.g. originated from unequal $\omega_1$ and $\omega_2$), may distribute asymmetrically across the structure, regardless of the symmetry of the input structure. Contact mechanics information 360 is determined based on load distribution information 356, kinematic information 358, and/or other information.

In some embodiments, determining contact mechanics information 360 comprises generating influential coefficient matrix 362 and/or other information. As described above, influential coefficient matrix 362 comprises kernel functions that relate surface deformation of the pad and the contact pressures. For example, the relationship between surface deformation of a pad, contact pressures, and the kernel functions is shown in Equation 1 below.

$$d(x) = W * p(x) \qquad [1]$$

In Equation 1, d(x) represents deformation at a given location (x) on a wafer, p(x) represents a pressure at that given location and W is the influential coefficient matrix. In some embodiments, coordinate (x) may be replaced by a two-dimensional coordinate (x,y), as an example, to calculate a two-dimensional pressure profile p(x,y).

Influential coefficient matrix 362 may be and/or include an initial influential coefficient matrix that is adjusted based on other contact mechanics information 360, load distribution information 356, kinematic information 358, and/or other information. For example, an initial influential coefficient matrix may be symmetric. In Hertzian contact theory, an influential coefficient matrix is a positive definite symmetric matrix. This symmetric influential coefficient matrix is used in many published models. However, the present method addresses asymmetric contact, which cause determination of an asymmetric influential coefficient matrix. Thus, influential coefficient matrix 362 is asymmetric, reflecting the differences in asperities, pressure, pad viscoelasticity, and/or friction forces (for example) across a structure on a substrate during chemical mechanical polishing. In other words, asymmetry is incorporated into the matrix W from Equation 1.

In some embodiments, at least a portion of the contact mechanics information is determined by a matrix inversion solver or a linear complimentary problem solver. Determining contact mechanics information 360 includes determining pressure profile 364. Pressure profile 364 is indicative of contact pressures between a wafer and a pad during chemical mechanical polishing. Pressure profile 364 may be an asymmetric pressure profile regardless of the symmetry of the input structure. In some embodiments, pressure profile 364 is determined by the matrix inversion solver or the linear complimentary problem solver. In some embodiments, the choice of whether to use the matrix inversion solver or the linear complimentary problem solver is entered and/or selected by a user via a user interface, for example, and/or by other methods.

Material removal information 366 may be and/or include information related to simulating removing material from the wafer based on the load distribution information, the kinematic information, the contact mechanics information, the input 400, the geometric representation of the structure 354, and/or other information; and predicting and/or otherwise determining the post chemical mechanical polishing surface topography of the wafer based on the load distribution information, the kinematic information, the contact mechanics information, and the removed material. In some embodiments, asymmetric pressure profile 364 and/or other information is used as input to determine material removal information 366. Material removal information 366 may include, and/or be used to determine output geometry 354, for example.

In some embodiments, material removal information 366 comprises a rate of material removal at given locations on the structure on a wafer substrate. A rate of material removal at given locations across the wafer may be removal rate profile, for example. The rate of material removal is determined based on the asymmetric pressure profile and/or other information. In some embodiments, the material removal and/or the surface topography is predicted using a material removal rate model 427. The model links the material removal rate to an explicit function of pressure and scalar polishing velocity. One such model is based on Preston's Equation and/or other information. Preston's Equation is reproduced as Equation 2 below:

$$ MRR(x,y) = K * v * p(x,y) \qquad [2] $$

In Equation 2, MRR is the material removal rate at a given location (x,y) on a wafer (e.g., a local material removal rate). K is a Preston's constant for a material (of a layer) of the wafer, v is the polishing velocity or speed, and p(x,y) is the asymmetric pressure profile across the structure at a given location on the wafer (e.g., comprising individual pressures at various points (x,y) across the structure). This example model is not intended to be limiting.

Output geometry 354 is a prediction and/or other determination of a post chemical mechanical polishing surface topography of a wafer based on load distribution information 356, kinematic information 358, contact mechanics information 360, material removal information 366, and/or other information. Output geometry 354 may be an asymmetric surface profile regardless of the asymmetry of the input geometry 352. In some embodiments, predicting and/or otherwise determining the post chemical mechanical polishing surface topography of the wafer comprises generating an output wafer stack height map and/or other information. The post chemical mechanical polishing surface topography of the wafer is predicted and/or otherwise determined based on load distribution information 356, kinematic information 358, contact mechanics information 360, material removal information 366, and/or other information for one or more of process modeling, metrology correction, feedforward control, or process integration for chemical mechanical polishing in a semiconductor manufacturing process. In some embodiments, output geometry 354 is used as input in an optical sensor model 399 as shown in Figure 10.

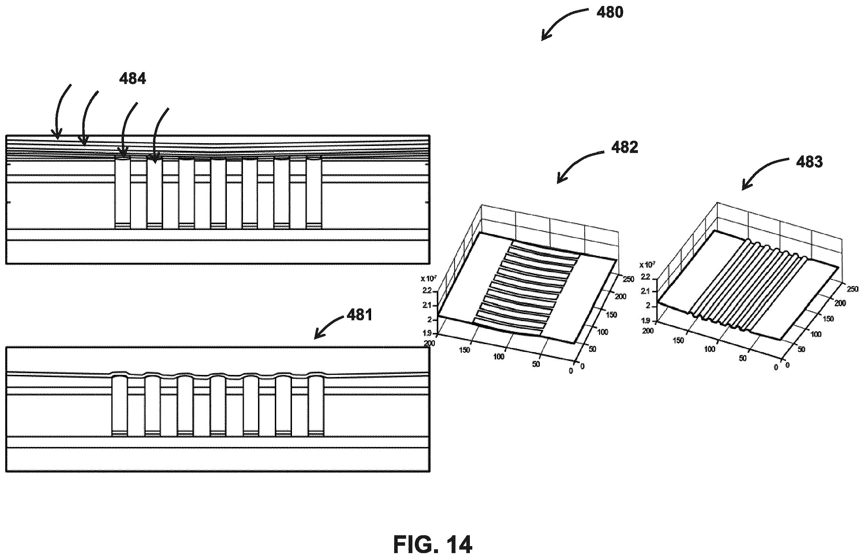

As an example, the post chemical mechanical polishing surface topography of the wafer may be used to predict grating asymmetry in optical alignment marks used in a semiconductor manufacturing process. The operations shown in Figure 10 may be iteratively repeated, for example, until an indicator (e.g. an optical response, a cumulated polishing time, a parameter defining certain geometric shape) of the structure of a modeled chemical mechanical polishing step reaches a threshold. As an example, Figure 14 illustrates cross-sectional views of output geometry 480 and 481. Figure 14 also illustrates surface topography of a unit cell of a y-direction segmented grating structure 482, and a unit cell of an x-direction segmented grating structure 483 after chemical mechanical polishing using three-dimensional simulation. In some embodiments (as in the example shown in Figure 14), the operations describe herein include assuming a periodic boundary condition to simulate grating structures such as the grating structures shown in Figure 14. Output geometry 480 illustrates an optical alignment mark (image is horizontally contracted 1:5 to exaggerate surface topography) with a pitch of 3.2 $\mu$m with sub-segments (and a sub-pitch of 120nm). Lines 484 track surface topography evolution during simulated chemical mechanical polishing. Output geometry 481 illustrates the same mark (image is horizontally contracted 1:5 to exaggerate surface topography) but with simulation of a 3-step chemical mechanical polishing process (bulk chemical mechanical polishing + fine chemical mechanical polishing + barrier removal) and with applied coatings. The geometric asymmetry of the unit cell of the periodic grating structure is illustrated in 480 and 481 with an arrow pointing to a lowest point on the top surface biasing from the image center line.

As mentioned earlier, inspection of, e.g., semiconductor wafers is often done with optics-based sub-resolution tools (bright-field inspection). But, in some cases, certain features to be measured are too small to be effectively measured using bright-field inspection. For example, bright-field inspection of defects in features of a semiconductor device can be challenging. Moreover, as time progresses, features that are being made using patterning processes (e.g., semiconductor features made using lithography) are becoming smaller and in many cases, the density of features is also increasing. Accordingly, a higher resolution inspection technique is used and desired. An example inspection technique is electron beam inspection. Electron beam inspection involves focusing a beam of electrons on a small spot on the substrate to be inspected. An image is formed by providing relative movement between the beam and the substrate (hereinafter referred to as scanning the electron beam) over the area of the substrate inspected and collecting secondary and/or backscattered electrons with an electron detector. The image data is then processed to, for example, identify defects.

So, in an embodiment, the inspection apparatus may be an electron beam inspection apparatus (e.g., the same as or similar to a scanning electron microscope (SEM)) that yields an image of a structure (e.g., some or all the structure of a device, such as an integrated circuit) exposed or transferred on the substrate.

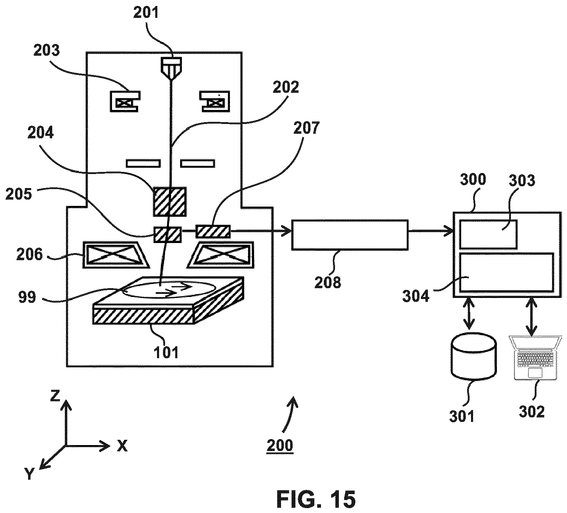

Figure 15 schematically depicts an embodiment of an electron beam inspection apparatus 200. A primary electron beam 202 emitted from an electron source 201 is converged by condenser lens 203 and then passes through a beam deflector 204, an E x B deflector 205, and an objective lens 206 to irradiate a substrate 99 on a substrate table 101 at a focus.

When the substrate 99 is irradiated with electron beam 202, secondary electrons are generated from the substrate 99. The secondary electrons are deflected by the E x B deflector 205 and detected by a secondary electron detector 207. A two-dimensional electron beam image can be obtained by detecting the electrons generated from the sample in synchronization with, e.g., two dimensional scanning of the electron beam by beam deflector 204 or with repetitive scanning of electron beam 202 by beam deflector 204 in an X or Y direction, together with continuous movement of the substrate 99 by the substrate table 101 in the other of the X or Y direction. Thus, in an embodiment, the electron beam inspection apparatus has a field of view for the electron beam defined by the angular range into which the electron beam can be provided by the electron beam inspection apparatus (e.g., the angular range through which the deflector 204 can provide the electron beam 202). Thus, the spatial extent of the field of the view is the spatial extent to which the angular range of the electron beam can impinge on a surface (wherein the surface can be stationary or can move with respect to the field).

A signal detected by secondary electron detector 207 is converted to a digital signal by an analog/digital (A/D) converter 208, and the digital signal is sent to an image processing system 300. In an embodiment, the image processing system 300 may have memory 303 to store all or part of digital images for processing by a processing unit 304. The processing unit 304 (e.g., specially designed hardware or a combination of hardware and software or a computer readable medium comprising software) is configured to convert or process the digital images into datasets representative of the digital images. In an embodiment, the processing unit 304 is configured or programmed to cause execution of a method described herein. Further, image processing system 300 may have a storage medium 301 configured to store the digital images and corresponding datasets in a reference database. A display device 302 may be connected with the image processing system 300, so that an operator can conduct necessary operation of the equipment with the help of a graphical user interface.

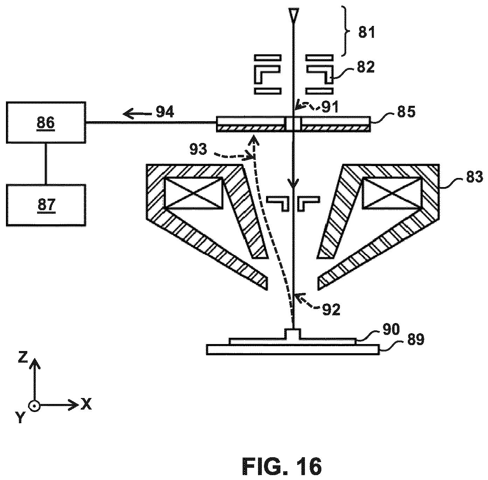

Figure 16 schematically illustrates a further embodiment of an inspection apparatus. The system is used to inspect a sample 90 (such as a substrate) on a sample stage 89 and comprises a charged particle beam generator 81, a condenser lens module 82, a probe forming objective lens module 83, a charged particle beam deflection module 84, a secondary charged particle detector module 85, and an image forming module 86.

The charged particle beam generator 81 generates a primary charged particle beam 91. The condenser lens module 82 condenses the generated primary charged particle beam 91. The probe forming objective lens module 83 focuses the condensed primary charged particle beam into a charged particle beam probe 92. The charged particle beam deflection module 84 scans the formed charged particle beam probe 92 across the surface of an area of interest on the sample 90 secured on the sample stage 89. In an embodiment, the charged particle beam generator 81, the condenser lens module 82 and the probe forming objective lens module 83, or their equivalent designs, alternatives or any combination thereof, together form a charged particle beam probe generator that generates the scanning charged particle beam probe 92.

The secondary charged particle detector module 85 detects secondary charged particles 93 emitted from the sample surface (maybe also along with other reflected or scattered charged particles from the sample surface) upon being bombarded by the charged particle beam probe 92 to generate a secondary charged particle detection signal 94. The image forming module 86 (e.g., a computing device) is coupled with the secondary charged particle detector module 85 to receive the secondary charged particle detection signal 94 from the secondary charged particle detector module 85 and accordingly forming at least one scanned image. In an embodiment, the secondary charged particle detector module 85 and image-forming module 86, or their equivalent designs, alternatives or any combination thereof, together form an image forming apparatus that forms a scanned image from detected secondary charged particles emitted from sample 90 being bombarded by the charged particle beam probe 92.

In an embodiment, a monitoring module 87 is coupled to the image forming module 86 of the image forming apparatus to monitor, control, etc. the patterning process and/or derive a parameter for patterning process design, control, monitoring, etc. using the scanned image of the sample 90 received from image forming module 86. Therefore, in an embodiment, the monitoring module 87 is configured or programmed to cause execution of a method described herein. In an embodiment, the monitoring module 87 comprises a computing device. In an embodiment, the monitoring module 87 comprises a computer program to provide functionality herein and encoded on a computer readable medium forming, or disposed within, the monitoring module 87.

In an embodiment, like the electron beam inspection tool of Figure 15 that uses a probe to inspect a substrate, the electron current in the system of Figure 16 is significantly larger compared to, e.g., a CD SEM such as depicted in Figure 15, such that the probe spot is large enough so that the inspection speed can be fast. However, the resolution may not be as high as compared to a CD SEM because of the large probe spot. In an embodiment, the above discussed inspection apparatus (in Figures 15 or 16) may be single beam or a multi-beam apparatus without limiting the scope of the present disclosure.

The SEM images, from, e.g., the system of Figure 15 and/or Figure 16, may be processed to extract contours that describe the edges of objects, representing device structures, in the image. These contours are then typically quantified via metrics, such as CD, at user-defined cut-lines. Thus, typically, the images of device structures are compared and quantified via metrics, such as an edge-to-edge distance (CD) measured on extracted contours or simple pixel differences between images.

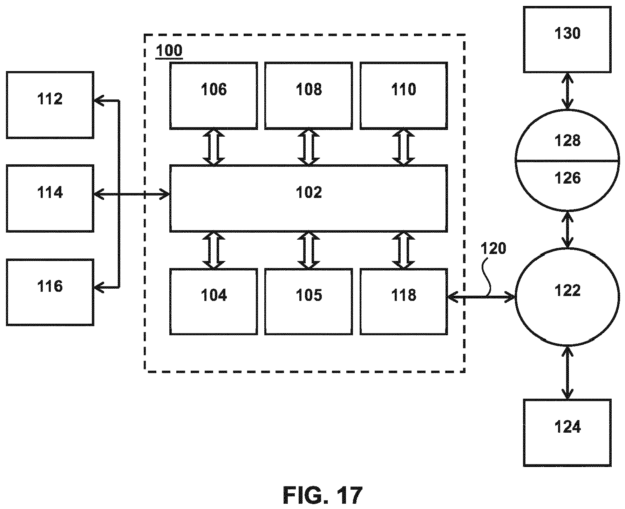

Figure 17 is a block diagram that illustrates a computer system 100 that can assist in implementing the optimization methods and flows disclosed herein. Computer system 100 includes a bus 102 or other communication mechanism for communicating information, and a processor 104 (or multiple processors 104 and 105) coupled with bus 102 for processing information. Computer system 100 also includes a main memory 106, such as a random access memory (RAM) or other dynamic storage device, coupled to bus 102 for storing information and instructions to be executed by processor 104. Main memory 106 also may be used for storing temporary variables or other intermediate information during execution of instructions to be executed by processor 104. Computer system 100 further includes a read only memory (ROM) 108 or other static storage device coupled to bus 102 for storing static information and instructions for processor 104. A storage device 110, such as a magnetic disk or optical disk, is provided and coupled to bus 102 for storing information and instructions.

Computer system 100 may be coupled via bus 102 to a display 112, such as a cathode ray tube (CRT) or flat panel or touch panel display for displaying information to a computer user. An input device 114, including alphanumeric and other keys, is coupled to bus 102 for communicating information and command selections to processor 104. Another type of user input device is cursor control 116, such as a mouse, a trackball, or cursor direction keys for communicating direction information and command selections to processor 104 and for controlling cursor movement on display 112. This input device typically has two degrees of freedom in two axes, a first axis (e.g., x) and a second axis (e.g., y), that allows the device to specify positions in a plane. A touch panel (screen) display may also be used as an input device.

According to one embodiment, portions of a process described herein may be performed by computer system 100 in response to processor 104 executing one or more sequences of one or more instructions contained in main memory 106. Such instructions may be read into main memory 106 from another computer-readable medium, such as storage device 110. Execution of the sequences of instructions contained in main memory 106 causes processor 104 to perform the process steps described herein. One or more processors in a multi-processing arrangement may also be employed to execute the sequences of instructions contained in main memory 106. In alternative embodiments, hard-wired circuitry may be used in place of or in combination with software instructions. Thus, embodiments are not limited to any specific combination of hardware circuitry and software.

The term "computer-readable medium" as used herein refers to any medium that participates in providing instructions to processor 104 for execution. Such a medium may take many forms, including but not limited to, non-volatile media, volatile media, and transmission media. Non-volatile media include, for example, optical or magnetic disks, such as storage device 110. Volatile media include dynamic memory, such as main memory 106. Transmission media include coaxial cables, copper wire and fiber optics, including the wires that comprise bus 102. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 104 for execution. For example, the instructions may initially be borne on a magnetic disk of a remote computer. The remote computer can load the instructions into its dynamic memory and send the instructions over a telephone line using a modem. A modem local to computer system 100 can receive the data on the telephone line and use an infrared transmitter to convert the data to an infrared signal. An infrared detector coupled to bus 102 can receive the data carried in the infrared signal and place the data on bus 102. Bus 102 carries the data to main memory 106, from which processor 104 retrieves and executes the instructions. The instructions received by main memory 106 may optionally be stored on storage device 110 either before or after execution by processor 104.

Computer system 100 may also include a communication interface 118 coupled to bus 102. Communication interface 118 provides a two-way data communication coupling to a network link 120 that is connected to a local network 122. For example, communication interface 118 may be an integrated services digital network (ISDN) card or a modem to provide a data communication connection to a corresponding type of telephone line. As another example, communication interface 118 may be a local area network (LAN) card to provide a data communication connection to a compatible LAN. Wireless links may also be implemented. In any such implementation, communication interface 118 sends and receives electrical, electromagnetic or optical signals that carry digital data streams representing various types of information.

Network link 120 typically provides data communication through one or more networks to other data devices. For example, network link 120 may provide a connection through local network 122 to a host computer 124 or to data equipment operated by an Internet Service Provider (ISP) 126. ISP 126 in turn provides data communication services through the worldwide packet data communication network, now commonly referred to as the "Internet" 128. Local network 122 and Internet 128 both use electrical, electromagnetic or optical signals that carry digital data streams. The signals through the various networks and the signals on network link 120 and through communication interface 118, which carry the digital data to and from computer system 100, are exemplary forms of carrier waves transporting the information.

Computer system 100 can send messages and receive data, including program code, through the network(s), network link 120, and communication interface 118. In the Internet example, a server 130 might transmit a requested code for an application program through Internet 128, ISP 126, local network 122 and communication interface 118. In accordance with one or more embodiments, one such downloaded application provides for the illumination optimization of the embodiment, for example. The received code may be executed by processor 104 as it is received, and/or stored in storage device 110, or other non-volatile storage for later execution. In this manner, computer system 100 may obtain application code in the form of a carrier wave.

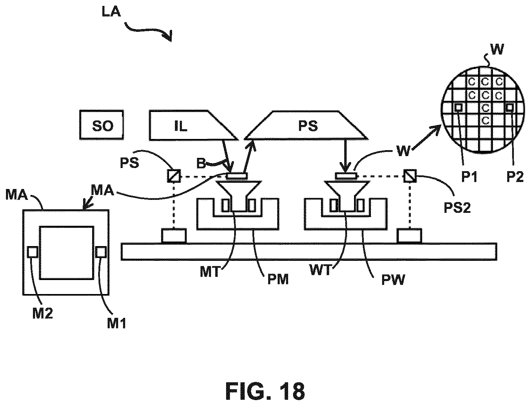

Figure 18 schematically depicts another exemplary lithographic projection apparatus LA that includes:

- a source collector module SO to provide radiation.
- an illumination system (illuminator) IL configured to condition a radiation beam B (e.g. EUV radiation) from the source collector module SO.

- a support structure (e.g. a mask table) MT constructed to support a patterning device (e.g. a mask or a reticle) MA and connected to a first positioner PM configured to accurately position the patterning device;
- a substrate table (e.g. a wafer table) WT constructed to hold a substrate (e.g. a resist coated wafer) W and connected to a second positioner PW configured to accurately position the substrate; and
- a projection system (e.g. a reflective projection system) PS configured to project a pattern imparted to the radiation beam B by patterning device MA onto a target portion C (e.g. comprising one or more dies) of the substrate W.

As here depicted, the apparatus LA is of a reflective type (e.g. employing a reflective mask). It is to be noted that because most materials are absorptive within the EUV wavelength range, the patterning device may have multilayer reflectors comprising, for example, a multi-layer stack of molybdenum and silicon. In one example, the multi-stack reflector has a 40 layer pairs of Molybdenum and Silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

Referring to Figure 18, the illuminator IL receives an extreme ultra violet radiation beam from the source collector module SO. Methods to produce EUV radiation include, but are not necessarily limited to, converting a material into a plasma state that has at least one element, e.g., xenon, lithium or tin, with one or more emission lines in the EUV range. In one such method, often termed laser-produced plasma ("LPP") the plasma can be produced by irradiating a fuel, such as a droplet, stream or cluster of material having the line-emitting element, with a laser beam. The source collector module SO may be part of an EUV radiation system including a laser, not shown in Figure 16, for providing the laser beam exciting the fuel. The resulting plasma emits output radiation, e.g., EUV radiation, which is collected using a radiation collector, disposed in the source collector module. The laser and the source collector module may be separate entities, for example when a $CO_2$ laser is used to provide the laser beam for fuel excitation.

In such cases, the laser is not considered to form part of the lithographic apparatus and the radiation beam is passed from the laser to the source collector module with the aid of a beam delivery system comprising, for example, suitable directing mirrors and/or a beam expander. In other cases, the radiation source may be an integral part of the source collector module, for example, when the radiation source is a discharge produced plasma EUV generator, often termed as a DPP radiation source.

The illuminator IL may comprise an adjuster for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B is incident on the patterning device (e.g., mask) MA, which is held on the support structure (e.g., mask table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder or capacitive sensor), the substrate table WT can be moved accurately, e.g. so as to position different target portions C in the path of the radiation beam B. Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks P1, P2.

The depicted apparatus LA could be used in at least one of the following modes:

1. In step mode, the support structure (e.g. mask table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed.

2. In scan mode, the support structure (e.g. mask table) MT and the substrate table WT are scanned synchronously while a pattern imparted to the radiation beam is projected onto a target portion C (i.e. a single dynamic exposure). The velocity and direction of the substrate table WT relative to the support structure (e.g. mask table) MT may be determined by the (de-)magnification and image reversal characteristics of the projection system PS.

3. In another mode, the support structure (e.g. mask table) MT is kept essentially stationary holding a programmable patterning device, and the substrate table WT is moved or scanned while a pattern imparted to the radiation beam is projected onto a target portion C. In this mode, generally, a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

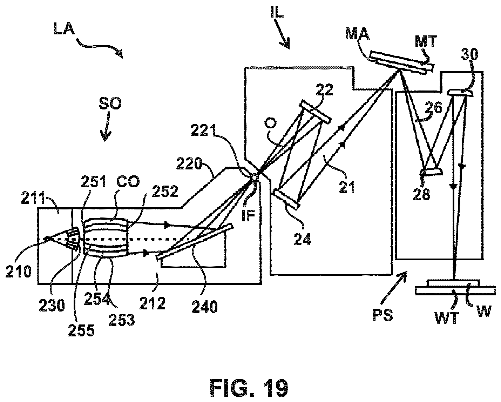

Figure 19 shows the apparatus LA in more detail, including the source collector module SO, the illumination system IL, and the projection system PS. The source collector module SO is constructed and arranged such that a vacuum environment can be maintained in an enclosing structure 220 of the source collector module SO. An EUV radiation-emitting plasma 210 may be formed by a discharge produced plasma radiation source. EUV radiation may be produced by a gas or vapor, for example Xe gas, Li vapor or Sn vapor in which the very hot plasma 210 is created to emit radiation in the EUV range of the electromagnetic spectrum. The very hot plasma 210 is created by, for example, an electrical discharge causing an at least partially ionized plasma. Partial pressures of, for example, 10 Pa of Xe, Li, Sn vapor or any other suitable gas or vapor may be required for efficient generation of the radiation. In an embodiment, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier 230 further indicated herein at least includes a channel structure, as known in the art.

The collector chamber 211 may include a radiation collector CO that may be a so-called grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the dot-dashed line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT.

More elements than shown may generally be present in illumination optics unit IL and projection system PS. The grating spectral filter 240 may optionally be present, depending upon the type of lithographic apparatus. Further, there may be more mirrors present than those shown in the Figures, for example there may be 1 - 6 additional reflective elements present in the projection system PS than shown in Figure 17.

Collector optic CO, as illustrated in Figure 18, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type is desirably used in combination with a discharge produced plasma radiation source.

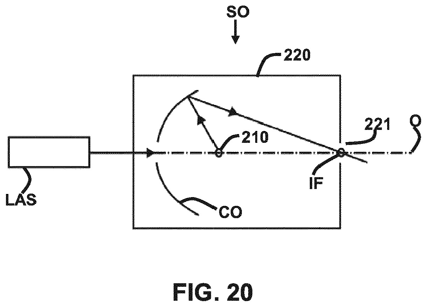

Alternatively, the source collector module SO may be part of an LPP radiation system as shown in Figure 20. A laser LAS is arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

The embodiments may further be described using the following clauses:

1. A method for facilitating chemical mechanical polishing, the method comprising:

determining contact mechanics information indicative of contact pressures and friction forces between a wafer and a pad during the chemical mechanical polishing at a plurality of locations across the wafer, the contact pressures and friction forces asymmetrically distributed across the wafer; and
determining a post chemical mechanical polishing surface topography of the wafer based at least on the contact mechanics information;
wherein the post chemical mechanical polishing surface topography of the wafer is determined for one or more of process modeling, metrology correction, feedforward control, or process integration for chemical mechanical polishing in a semiconductor manufacturing process.

2. The method of clause 1, further comprising determining load distribution information indicative of forces between the wafer and the pad during the chemical mechanical polishing, the load distribution information determined based on asperities of the wafer and the pad; and

determining kinematic information comprising one or more parameters related to motion of the wafer and the pad during the chemical mechanical polishing;
wherein the contact mechanics information is determined based on the load distribution information and the kinematic information; and
wherein determining the post chemical mechanical polishing surface topography of the wafer is further based on the load distribution information and the kinematic information.

3. The method of any of clauses 1-2, wherein determining the contact mechanics information comprises generating an influential coefficient matrix comprising kernel functions that relate surface deformation of the wafer and the contact pressures.

4. The method of clause 3, wherein the influential coefficient matrix is asymmetric.

5. The method of any of clauses 1-4, further comprising obtaining geometric parameters associated with the wafer, and determining the post chemical mechanical polishing surface topography of the wafer based on the load distribution information, the kinematic information, the contact mechanics information, and the geometric parameters associated with the wafer.

6. A method for facilitating chemical mechanical polishing, the method comprising:

determining contact mechanics information indicative of contact pressures and friction forces between a wafer and a pad during the chemical mechanical polishing at a plurality of locations across the wafer, the contact pressures and friction forces asymmetrically distributed across the wafer; and
determining a post chemical mechanical polishing surface topography of the wafer based at least on the contact mechanics information.

7. The method of clause 6, further comprising determining load distribution information indicative of forces between the wafer and the pad during the chemical mechanical polishing, the load distribution information determined based on asperities of the wafer and the pad; and

determining kinematic information comprising one or more parameters related to motion of the wafer and the pad during the chemical mechanical polishing;
wherein the contact mechanics information is determined based on the load distribution information and the kinematic information; and
wherein determining the post chemical mechanical polishing surface topography of the wafer is further based on the load distribution information and the kinematic information.

8. The method of clause 7, wherein determining the contact mechanics information comprises generating an influential coefficient matrix comprising kernel functions that relate surface deformation of the wafer and the contact pressures.

9. The method of clause 8, wherein the influential coefficient matrix is asymmetric.

10. The method of any of clauses 7-9, further comprising obtaining geometric parameters associated with the wafer, and determining the post chemical mechanical polishing surface topography of the wafer based on the load distribution information, the kinematic information, the contact mechanics information, and the geometric parameters associated with the wafer.

11. The method of clause 10, wherein the geometric parameters associated with the wafer include one or more of a pre-chemical mechanical polishing surface topography, parameters related to materials in a wafer stack of the wafer, a wafer stack height map, or coordinates of one or more locations on the wafer.

12. The method of any of clauses 7-11, further comprising obtaining physical parameters associated with the wafer, the pad, and/or a simulated chemical mechanical polishing process; and determining the load distribution information, the kinematic information, and/or the contact mechanics information based on the physical parameters.

13. The method of clause 12, wherein the physical parameters comprise one or more of an elastic or dynamic modulus of the pad, a Poisson ratio for the pad, a pad asperity model, a pad asperity height distribution curve, a pad asperity tip radius distribution curve, a pad asperity density, an elastic modulus of the wafer, a Poisson ratio for the wafer, a polishing speed constant, a friction coefficient, a pad rotation speed, a wafer rotation speed, a distance between the wafer and the pad, or Preston's constants related to a simulated polishing slurry.

14. The method of any of clauses 7-13, further comprising simulating removing material from the wafer based on the load distribution information, the kinematic information, and the contact mechanics information, and determining the post chemical mechanical polishing surface topography of the wafer based on the load distribution information, the kinematic information, the contact mechanics information, and the removed material.

15. The method of any of clauses 7-14, wherein the load distribution information comprises a number of points on the wafer where asperity loads are discretized.

16. The method of clause 15, wherein the number of points is adjustable.

17. The method of any of clauses 7-16, wherein one of the one or more parameters related to the motion of the wafer and the pad is a number of polishing directions.

18. The method of clause 17, wherein the number of polishing directions is adjustable.

19. The method of any of clauses 7-18, wherein at least a portion of the contact mechanics information is determined by a matrix inversion solver or a linear complimentary problem solver.

20. The method of any of clauses 7-19, wherein the contact mechanics information comprises an asymmetric pressure profile.

21. The method of any of clauses 7-20, wherein the post chemical mechanical polishing surface topography of the wafer is determined based on the load distribution information, the kinematic information, and the contact mechanics information for one or more of process modeling, metrology correction, feedforward control, or process integration for chemical mechanical polishing in a semiconductor manufacturing process.

22. The method of any of clauses 7-21, wherein the post chemical mechanical polishing surface topography of the wafer is used to determine grating asymmetry in optical alignment marks used in a semiconductor manufacturing process.

23. The method of any of clauses 7-22, wherein determining the post chemical mechanical polishing surface topography of the wafer based on the load distribution information, the kinematic information, and the contact mechanics information comprises generating an output wafer stack height map.

24. The method of any of clauses 7-23, wherein the post chemical mechanical polishing surface topography of the wafer is further determined based on Preston's Equation.

25. The method of any of clauses 7-24, wherein the asperities of the wafer and the pad are determined based on a pad asperity model and a stack height map of the wafer.

26. The method of any of clauses 7-25, further comprising causing, based on the determined post chemical mechanical polishing surface topography, performance of the chemical mechanical polishing.

27. A computer program product comprising a non-transitory computer readable medium having instructions recorded thereon, the instructions when executed by a computer implementing the method of any of clauses 6-26.

28. A method for facilitating chemical mechanical polishing, the method comprising:

determining contact mechanics information indicative of contact pressures and friction forces between a wafer and a pad during the chemical mechanical polishing at a plurality of locations across the wafer, the contact pressures and friction forces asymmetrically distributed across the wafer;

determining a post chemical mechanical polishing surface topography of the wafer based at least on the contact mechanics information; and

causing, based on the determined post chemical mechanical polishing surface topography, performance of the chemical mechanical polishing.

The concepts disclosed herein may simulate or mathematically model any generic imaging system for imaging sub wavelength features, and may be especially useful with emerging imaging technologies capable of producing wavelengths of an increasingly smaller size. Emerging technologies already in use include DUV (deep ultra violet) lithography that is capable of producing a 193nm wavelength with the use of an ArF laser, and even a 157nm wavelength with the use of a Fluorine laser. Moreover, EUV lithography is capable of producing wavelengths within a range of 20-5nm by using a synchrotron or by hitting a material (either solid or a plasma) with high-energy electrons in order to produce photons within this range.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

Although specific reference may be made in this text to the use of embodiments in the manufacture of ICs, it should be understood that the embodiments herein may have many other possible applications. For example, it may be employed in the manufacture of integrated optical systems, guidance and detection patterns for magnetic domain memories, liquid-crystal displays (LCDs), thin film magnetic heads, micromechanical systems (MEMs), etc. The skilled artisan will appreciate that, in the context of such alternative applications, any use of the terms "reticle", "wafer" or "die" herein may be considered as synonymous or interchangeable with the more general terms "patterning device", "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create, for example, a multilayer IC, so that the term substrate used herein may also refer to a substrate that already contains multiple processed layers.

In the present document, the terms "radiation" and "beam" as used herein encompass all types of electromagnetic radiation, including ultraviolet radiation (e.g. with a wavelength of about 365, about 248, about 193, about 157 or about 126 nm) and extreme ultra-violet (EUV) radiation (e.g. having a wavelength in the range of 5-20 nm), as well as particle beams, such as ion beams or electron beams.

The terms "optimizing" and "optimization" as used herein refers to or means adjusting a patterning apparatus (e.g., a lithography apparatus), a patterning process, etc. such that results and/or processes have more desirable characteristics, such as higher accuracy of projection of a design pattern on a substrate, a larger process window, etc. Thus, the term "optimizing" and "optimization" as used herein refers to or means a process that identifies one or more values for one or more parameters that provide an improvement, e.g. a local optimum, in at least one relevant metric, compared to an initial set of one or more values for those one or more parameters. "Optimum" and other related terms should be construed accordingly. In an embodiment, optimization steps can be applied iteratively to provide further improvements in one or more metrics.

Aspects of the invention can be implemented in any convenient form. For example, an embodiment may be implemented by one or more appropriate computer programs which may be carried on an appropriate carrier medium which may be a tangible carrier medium (e.g. a disk) or an intangible carrier medium (e.g. a communications signal). Embodiments of the invention may be implemented using suitable apparatus, which may specifically take the form of a programmable computer running a computer program, arranged to implement a method as described herein. Thus, embodiments of the disclosure may be implemented in hardware, firmware, software, or any combination thereof. Embodiments of the disclosure may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic disk storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc.

In block diagrams, illustrated components are depicted as discrete functional blocks, but embodiments are not limited to systems in which the functionality described herein is organized as illustrated. The functionality provided by each of the components may be provided by software or hardware modules that are differently organized than is presently depicted, for example such software or hardware may be intermingled, conjoined, replicated, broken up, distributed (e.g. within a data center or geographically), or otherwise differently organized. The functionality described herein may be provided by one or more processors of one or more computers executing code stored on a tangible, non-transitory, machine-readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, these inventions have been grouped into a single document because their related subject matter lends itself to economies in the application process. However, the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

It should be understood that the description and the drawings are not intended to limit the present disclosure to the particular form disclosed, but to the contrary, the intention is to cover all modifications, equivalents, and alternatives falling within the spirit and scope of the inventions as defined by the appended claims.

Modifications and alternative embodiments of various aspects of the inventions will be apparent to those skilled in the art in view of this description. Accordingly, this description and the drawings are to be construed as illustrative only and are for the purpose of teaching those skilled in the art the general manner of carrying out the inventions. It is to be understood that the forms of the inventions shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description. Changes may be made in the elements described herein without departing from the spirit and scope of the invention as described in the following claims. Headings used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include", "including", and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, non-exclusive, i.e., encompassing both "and" and "or." Terms describing conditional relationships, e.g., "in response to X, Y," "upon X, Y," "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every. References to selection from a range includes the end points of the range.

In the above description, any processes, descriptions or blocks in flowcharts should be understood as representing modules, segments or portions of code which include one or more executable instructions for implementing specific logical functions or steps in the process, and alternate implementations are included within the scope of the exemplary embodiments of the present advancements in which functions can be executed out of order from that shown or discussed, including substantially concurrently or in reverse order, depending upon the functionality involved, as would be understood by those skilled in the art.

To the extent certain U.S. patents, U.S. patent applications, or other materials (e.g., articles) have been incorporated by reference, the text of such U.S. patents, U.S. patent applications, and other materials is only incorporated by reference to the extent that no conflict exists between such material and the statements and drawings set forth herein. In the event of such conflict, any such conflicting text in such incorporated by reference U.S. patents, U.S. patent applications, and other materials is specifically not incorporated by reference herein.

While certain embodiments have been described, these embodiments have been presented by way of example only, and are not intended to limit the scope of the present disclosures. Indeed, the novel methods, apparatuses and systems described herein can be embodied in a variety of other forms; furthermore, various omissions, substitutions and changes in the form of the methods, apparatuses and systems described herein can be made without departing from the spirit of the present disclosures. The accompanying claims and their equivalents are intended to cover such forms or modifications as would fall within the scope and spirit of the present disclosures.

**Claims**

1. A method for facilitating chemical mechanical polishing, the method comprising:

   determining contact mechanics information indicative of contact pressures and friction forces between a wafer and a pad during the chemical mechanical polishing at a plurality of locations across the wafer, the contact pressures and friction forces asymmetrically distributed across the wafer; and
   determining a post chemical mechanical polishing surface topography of the wafer based at least on the contact mechanics information.

2. The method of claim 1, further comprising determining load distribution information indicative of forces between the wafer and the pad during the chemical mechanical polishing, the load distribution information determined based on asperities of the wafer and the pad; and
determining kinematic information comprising one or more parameters related to motion of the wafer and the pad during the chemical mechanical polishing;
wherein the contact mechanics information is determined based on the load distribution information and the kinematic information; and
wherein determining the post chemical mechanical polishing surface topography of the wafer is further based on the load distribution information and the kinematic information.

3. The method of claim 1, wherein determining the contact mechanics information comprises generating an influential coefficient matrix comprising kernel functions that relate surface deformation of the wafer and the contact pressures.

4. The method of claim 3, wherein the influential coefficient matrix is asymmetric.

5. The method of claim 2, further comprising obtaining geometric parameters associated with the wafer, and determining the post chemical mechanical polishing surface topography of the wafer based on the load distribution information, the kinematic information, the contact mechanics information, and the geometric parameters associated with the wafer.

6. The method of claim 5, wherein the geometric parameters associated with the wafer include one or more of a pre-chemical mechanical polishing surface topography, parameters related to materials in a wafer stack of the wafer, a wafer stack height map, or coordinates of one or more locations on the wafer.

7. The method claim 2, further comprising obtaining physical parameters associated with the wafer, the pad, and/or a simulated chemical mechanical polishing process; and determining the load distribution information, the kinematic information, and/or the contact mechanics information based on the physical parameters and/or
wherein the physical parameters comprise one or more of an elastic or dynamic modulus of the pad, a Poisson ratio for the pad, a pad asperity model, a pad asperity height distribution curve, a pad asperity tip radius distribution curve, a pad asperity density, an elastic modulus of the wafer, a Poisson ratio for the wafer, a polishing speed constant, a friction coefficient, a pad rotation speed, a wafer rotation speed, a distance between the wafer and the pad, or Preston's constants related to a simulated polishing slurry.

8. The method of claim 2, further comprising simulating removing material from the wafer based on the load distribution information, the kinematic information, and the contact mechanics information, and determining the post chemical mechanical polishing surface topography of the wafer based on the load distribution information, the kinematic information, the contact mechanics information, and the removed material.

9. The method of claim 2, wherein the load distribution information comprises a number of points on the wafer where asperity loads are discretized and/or wherein the number of points is adjustable.

10. The method of claim 2, wherein one of the one or more parameters related to the motion of the wafer and the pad is a number of polishing directions, and/or
wherein the number of polishing directions is adjustable.

11. The method of claim 2, wherein at least a portion of the contact mechanics information is determined by a matrix inversion solver or a linear complimentary problem solver.

12. The method of claim 2, wherein the contact mechanics information comprises an asymmetric pressure profile.

13. The method of claim 2, wherein the post chemical mechanical polishing surface topography of the wafer is determined based on the load distribution information, the kinematic information, and the contact mechanics information for one or more of process modeling, metrology correction, feedforward control, or process integration for chemical mechanical polishing in a semiconductor manufacturing process.

14. The method of claim 2, wherein the post chemical mechanical polishing surface topography of the wafer is used to determine grating asymmetry in optical alignment marks used in a semiconductor manufacturing process.

15. A computer program product comprising a non-transitory computer readable medium having instructions recorded thereon, the instructions when executed by a computer implementing the method of claim 1.

FIG. 1

FIG. 2

**FIG. 3**

**FIG. 4**

**FIG. 5**

FIG. 6

| 275 | → | 277 | → | 279 | → | 281 | → | 283 |

**FIG. 7A**

| 285 | → | 287 | → | 289 | → | 291 | → | 293 | → | 295 |

**FIG. 7B**

| 296 | → | 297 | → | 298 | → | 299 |

**FIG. 7C**

FIG. 8

**FIG. 9**

**FIG. 10**

EP 3 640 972 A1

FIG. 11

EP 3 640 972 A1

**FIG. 12**

39

FIG. 13

FIG. 14

**FIG. 15**

**FIG. 16**

FIG. 17

**FIG. 18**

**FIG. 19**

**FIG. 20**

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/147940 A1 (BENVEGNU DOMINIC J [US] ET AL) 28 May 2015 (2015-05-28) | 1,15 | INV. |
| A | * paragraphs [0003] - [0006] * <br> * paragraph [0043]; figure 3C * <br> * paragraphs [0051] - [0058] * <br> * paragraphs [0064] - [0073]; figure 4 * | 2-14 | H01L21/306 <br> H01L21/321 <br> B24B37/00 <br> B24B49/00 <br> B24B49/04 <br> B24B49/12 |
| X | US 2012/277897 A1 (ZHANG HUANBO [US] ET AL) 1 November 2012 (2012-11-01) | 1,15 | B24B49/16 <br> H01L21/66 |
| A | * paragraphs [0003] - [0009] * <br> * paragraphs [0034] - [0038]; figure 3 * <br> * paragraphs [0047] - [0052] * <br> * paragraphs [0072] - [0073]; figure 8 * | 2-14 | |
| A | US 2018/250788 A1 (LAU ERIC [US] ET AL) 6 September 2018 (2018-09-06) <br> * paragraphs [0035] - [0036] * <br> * paragraphs [0068] - [0070]; figure 10 * | 1-15 | |
| A | US 2017/190016 A9 (L LIVERMORE NAT SECURITY LLC [US]) 6 July 2017 (2017-07-06) <br> * paragraphs [0045] - [0054]; figure 3 * | 1-15 | TECHNICAL FIELDS SEARCHED (IPC) <br><br> H01L <br> B24D <br> B24B |

The present search report has been drawn up for all claims

| Place of search | Date of completion of the search | Examiner |
|---|---|---|
| Munich | 28 March 2019 | van Toledo, Wiebo |

# EP 3 640 972 A1

## ANNEX TO THE EUROPEAN SEARCH REPORT
## ON EUROPEAN PATENT APPLICATION NO.

EP 18 20 1087

28-03-2019

| Patent document cited in search report | | Publication date | Patent family member(s) | | Publication date |
|---|---|---|---|---|---|
| US 2015147940 | A1 | 28-05-2015 | CN | 105765707 A | 13-07-2016 |
| | | | JP | 2016540383 A | 22-12-2016 |
| | | | KR | 20160091408 A | 02-08-2016 |
| | | | TW | 201524681 A | 01-07-2015 |
| | | | US | 2015147940 A1 | 28-05-2015 |
| | | | WO | 2015080863 A1 | 04-06-2015 |
| US 2012277897 | A1 | 01-11-2012 | JP | 2014513434 A | 29-05-2014 |
| | | | KR | 20140028045 A | 07-03-2014 |
| | | | KR | 20170071609 A | 23-06-2017 |
| | | | TW | 201313392 A | 01-04-2013 |
| | | | TW | 201736043 A | 16-10-2017 |
| | | | US | 2012277897 A1 | 01-11-2012 |
| | | | US | 2014277670 A1 | 18-09-2014 |
| | | | US | 2016096251 A1 | 07-04-2016 |
| | | | WO | 2012148859 A2 | 01-11-2012 |
| US 2018250788 | A1 | 06-09-2018 | TW | 201835998 A | 01-10-2018 |
| | | | US | 2018250788 A1 | 06-09-2018 |
| | | | WO | 2018164804 A1 | 13-09-2018 |
| US 2017190016 | A9 | 06-07-2017 | CN | 101791783 A | 04-08-2010 |
| | | | EP | 2213412 A2 | 04-08-2010 |
| | | | EP | 3315257 A1 | 02-05-2018 |
| | | | JP | 5363367 B2 | 11-12-2013 |
| | | | JP | 2010173066 A | 12-08-2010 |
| | | | US | 2010311308 A1 | 09-12-2010 |
| | | | US | 2014335767 A1 | 13-11-2014 |

EPO FORM P0459

**REFERENCES CITED IN THE DESCRIPTION**

**Patent documents cited in the description**

- US 2006066855 A

- US 6961116 B

**Non-patent literature cited in the description**

- Full-Chip Lithography Simulation and Design Analysis - How OPC Is Changing IC Design. *C. Spence, Proc. SPIE,* 2005, vol. 5751, 1-14